(19) Europäisches Patentamt
European Patent Office
Office européen des brevets

(11) EP 1 439 422 A1

(12) EUROPEAN PATENT APPLICATION
published in accordance with Art. 158(3) EPC

(43) Date of publication:
**21.07.2004 Bulletin 2004/30**

(21) Application number: **02772967.2**

(22) Date of filing: **02.10.2002**

(51) Int Cl.7: **G03F 7/039**, H01L 21/027

(86) International application number:
**PCT/JP2002/010243**

(87) International publication number:
**WO 2003/036390 (01.05.2003 Gazette 2003/18)**

(84) Designated Contracting States:
**AT BE BG CH CY CZ DE DK EE ES FI FR GB GR IE IT LI LU MC NL PT SE SK TR**

(30) Priority: **03.10.2001 JP 2001307520**

(71) Applicants:
- **Semiconductor Leading Edge Technologies, Inc.**
  **Ibaraki-ken, 305-0053 (JP)**
- **Daikin Industries, Ltd.**
  **Osaka-shi, Osaka 530-8323 (JP)**

(72) Inventors:
- **TORIUMI, M.**
  **Tachikawa-shi, Tokyo 190-0002 (JP)**
- **YAMAZAKI, T.**
  **SEMICONDUCTOR LEADING EDGE TECH., INC**
  **Ibaraki305-0053 (JP)**
- **WATANABE, H.**
  **SEMICONDUCTOR LEADING EDGE TECH., INC**
  **Ibaraki 305-0053 (JP)**
- **ITANI, T.**
  **SEMICONDUCTOR LEADING EDGE TECH., INC.**
  **Ibaraki 305-0053 (JP)**
- **ARAKI, T.**
  **Yodogawa-seisakusho, DAIKIN IND., LTD.**
  **Osaka 566-8585 (JP)**
- **KOH, M., Yodogawa-seisakusho,**
  **Settsu-shi, Osaka 566-8585 (JP)**
- **ISHIKAWA, Takuji Yodogawa-seisakusho,**
  **Settsu-shi, Osaka 566-8585 (JP)**

(74) Representative: **HOFFMANN - EITLE**
**Patent- und Rechtsanwälte**
**Arabellastrasse 4**
**81925 München (DE)**

# (54) METHOD OF FORMING FINE PATTERN

(57) There is provided a method of forming, on a substrate, a fine resist pattern comprising a step for forming a photosensitive layer by using a photo-sensitive composition comprising at least a compound generating an acid by irradiation of light and a fluorine-containing polymer,
in which the fluorine-containing polymer is represented by the formula (1):

$$-(M1)-(M2)-(A1)- \qquad (1)$$

wherein the structural unit M1 is a structural unit derived from a fluorine-containing monomer, in which at least one fluorine atom is bonded to any of carbon atoms forming the polymer trunk chain,
the structural unit M2 is a structural unit having an aliphatic ring structure in the polymer trunk chain,
the structural unit A1 is a structural unit derived from a monomer copolymerizable with the monomers to introduce the structural units M1 and M2,
provided that at least any one of the structural units M1, M2 and A1 has an acid-reactive functional group Y, and contents of the structural units M1, M2 and A1 are from 1 to 99 % by mole, from 1 to 99 % by mole and from 0 to 98 % by mole, respectively, and
the polymer satisfies Equation (X): $N_T/(N_C - N_O + 4N_F{}^2) \leq 2.0$, wherein $N_T$ is a compositional average number of whole atoms constituting the fluorine-containing polymer, $N_C$ is a compositional average number of carbon atoms, No is a compositional average number of oxygen atoms and $N_F$ is a compositional average number of fluorine atoms bonded to carbon atoms of the polymer trunk chain and bonded to carbon atoms forming an aliphatic ring structure among fluorine atoms which constitute the fluorine-containing polymer. In the method of forming a fine pattern, the photosensitive composition having high practicality and prepared using a material having high transparency against exposure light having a short wavelength such as $F_2$ laser beam is used as a resist.

EP 1 439 422 A1

FIG. 1(a)

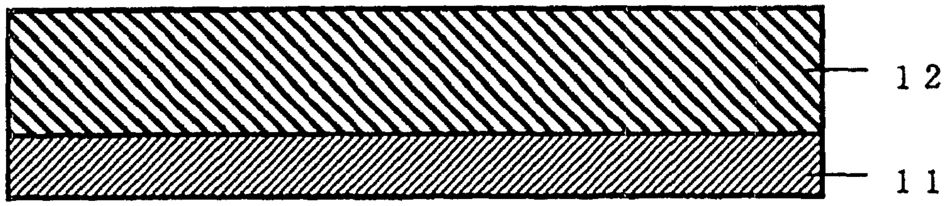


FIG. 1(b)

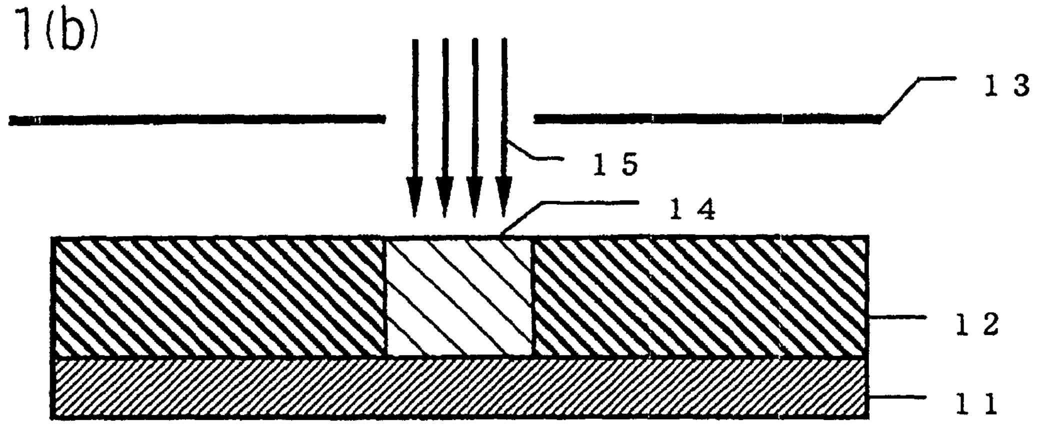


FIG. 1(c)

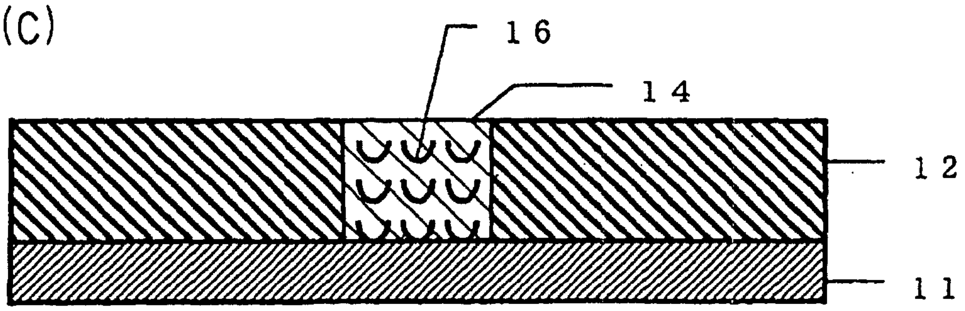


FIG. 1(d)

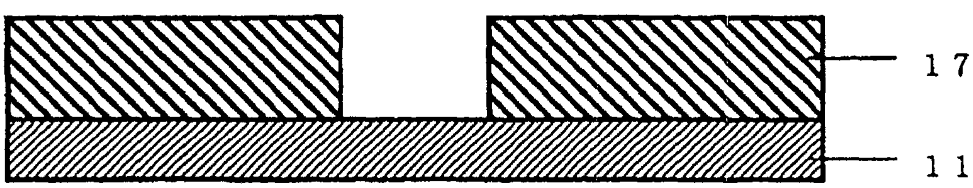

## Description

TECHNICAL FIELD

The present invention relates to a method of forming a fine pattern by using, as a resist, a highly practical photosensitive composition prepared using a material having both of dry etching resistance and high transparency in exposure light having a short wavelength such as $F_2$ laser beam.

BACKGROUND ART

Ultra fine fabrication is required for various electronic parts such as semiconductor integrated circuit, and a resist is widely used for a processing technology therefor. With the pursuit of multi functions and high density of electronic parts, ultra fine fabrication of a resist pattern to be formed is demanded. As the resist used for fabrication of such an ultra fine pattern, there are, for example, chemically amplifying resists disclosed in JP63-27829A, etc.
The chemically amplifying resists are broadly classified into a positive type resist and a negative type resist.
The positive type chemically amplifying resist is, for example, a three-component composition comprising an alkali-soluble resin, a dissolution inhibitor and an acid generator or a two-component composition comprising an alkali-soluble resin to which a group (protective group) having a dissolution-inhibiting effect is introduced and an acid generator. When the resist is in un-exposed state, solubility thereof in an alkali developing solution is inhibited by the dissolution-inhibiting group.
When the resist film formed on a substrate is irradiated with light, X-ray, high energy electron beam or the like, an acid generator is decomposed at an exposed portion and an acid is generated and when the resist film is further subjected to heat-treating after the exposure, the acid acts as a catalyst to decompose the dissolution inhibitor. Therefore an intended pattern can be formed by dissolving and removing, with a developing solution, the exposed portion in which the dissolution inhibitor has been decomposed. Finally a desired circuit pattern can be formed by subjecting the substrate or the layer on the substrate to etching through the formed resist pattern.
For forming a pattern using such a resist, a reduction projection exposure system usually called a stepper is generally used as an exposure system. As a result of a recent remarkable progress of multi functions and high density of electronic parts, a further fine circuit is demanded, which makes it necessary to form a fine pattern.
In the above-mentioned exposure system, since a pattern fabrication is carried out by projecting an optical image on a substrate, a limit of resolution depends on a wavelength of light used for the exposing. For the fine fabrication, a wavelength of light source used for the exposing has been shortened. It is a matter of certainty that in production of a device coming after a giga bit memory era, $F_2$ laser in a vacuum ultraviolet region having a wavelength of 157 nm will be mainly used as light source. Therefore, development of a chemically amplifying resist capable of forming a fine pattern using $F_2$ laser as light source has already been initiated.
However materials which have been used for conventional resist polymers have a large amount of absorption of $F_2$ laser beam having a wavelength of 157 nm. When $F_2$ laser beam is used for the exposing of a photosensitive composition prepared from such materials, sufficient amount of exposure beam does not reach the bottom of the resist. Therefore uniform exposing in the direction of a depth of the photosensitive composition formed on the substrate cannot be carried out, and it is difficult to enhance resolution.
In order to solve the problem with insufficient transparency, the use of a fluorine-containing polymer having small absorption of $F_2$ laser beam having a wavelength of 157 nm has been studied (Journal of Photopolymer Science and Technology (Vol.12, No.4 (1999) 561-569), WO00/17712, WO00/67072, JP2000-321774A, etc.).
It is necessary that a resist polymer has sufficient dry etching resistance, in order to form a desired circuit pattern by subjecting the substrate or the layer on the substrate to etching through the obtained resist pattern.
With respect to dry etching resistance of a resist polymer, various studies have been made as to a relation between the dry etching resistance and the polymer structure and some empirical relational formulae have been proposed.
Onishi, et al. disclosed that with respect to dry etching resistance of conventional resist polymer having no fluorine, an etching rate thereof is proportional to the equation (X-2) called Onishi parameter:

$$N_T/(N_C-N_O) \qquad \text{(X-2)}$$

wherein $N_T$: Total number of atoms, $N_C$: Number of carbon atoms, $N_O$: Number of oxygen atoms (J. Electrochem. Soc. 130, 143 (1983).
Also R.R. Kunz (Proc. SPIE2724, 365 (1996)), Ofuji (Proc. SPIE3333, 595 (1998)), et al. proposed empirical

formulae with respect to dry etching resistance of polymers having cyclic hydrocarbon structure.

On the other hand, dry etching resistance of resist polymers having fluorine atom has not been fully studied, but recently Kishimura, et al. have studied specific fluorine-containing polymers having fluorine atom and suggested that an etching rate thereof is proportional to equation (X-3):

$$N_T/(N_C-N_O-N_F') \qquad \text{(X-3)}$$

($N_T$: Total number of atoms, $N_C$: Number of carbon atoms, $N_O$: Number of oxygen atoms, $N_F'$: Number of fluorine atoms) and fluorine atoms lower dry etching resistance (preprint of 48th Joint Lecture Meeting of Applied Physics, 737, 29a-ZD-6 (2001.3.)).

However studies have not been made sufficiently as to a relation between dry etching resistance and a structure of a fluorine-containing polymer in which fluorine atom is bonded to carbon atom constituting its trunk chain (a polymer having fluorine atom in its trunk chain).

Namely, a preferable structure of a fluorine-containing polymer which possesses a high transparency against light in a vacuum ultraviolet region and excellent dry etching resistance has not yet been found.

## DISCLOSURE OF INVENTION

The present invention was made based on new findings to solve the above-mentioned problems, and an object of the present invention is to provide a method of forming a fine pattern using, as a resist, a highly practical photosensitive composition prepared from a material having dry etching resistance and high transparency in exposure light having a short wavelength such as $F_2$ laser beam.

The present inventors have made intensive studies to attain the mentioned object and as a result, have found a relation by rule of thumb between a dry etching rate and a specific fluorine-containing polymer in which fluorine atom is bonded to carbon atom constituting the polymer trunk chain (a polymer having fluorine atom in its trunk chain). As a result, the present inventors have found a fluorine-containing polymer for a resist having good dry etching resistance irrespective of a high fluorine content.

Namely, the present inventors have studied dry etching resistance of various fluorine-containing polymers. Though it has been deemed that dry etching resistance is lowered by introducing fluorine atom, the present inventors have found that with respect to a specific fluorine-containing polymer having fluorine atom in its trunk chain, when more fluorine atoms are introduced to a specific portion, dry etching resistance can be surprisingly enhanced significantly.

As a result, a fine circuit pattern highly practical as a semiconductor device can be obtained according to the method of forming a fine pattern of the present invention by using the mentioned fluorine-containing polymer having both of dry etching resistance and high transparency in exposure light having a short wavelength such as $F_2$ laser beam.

Namely, the present invention relates to a method of forming a fine resist pattern comprising a step for forming a photo-sensitive layer on a substrate or on a given layer on a substrate by using a photosensitive composition comprising at least a compound generating an acid by irradiation of light and a fluorine-containing polymer, a step for exposing by selectively irradiating a given area of the photosensitive layer with energy ray, a step for heat-treating the exposed photosensitive layer, and a step for forming a fine pattern by developing the heat-treated photosensitive layer to selectively remove the exposed portion or un-exposed portion of the photosensitive layer,
in which the fluorine-containing polymer is represented by the formula (1);

$$-(M1)-(M2)-(A1)- \qquad (1)$$

wherein the structural unit M1 is a structural unit derived from a fluorine-containing monomer, in which at least one fluorine atom is bonded to any of carbon atoms forming the polymer trunk chain,
the structural unit M2 is a structural unit having an aliphatic ring structure in the polymer trunk chain,
the structural unit A1 is a structural unit derived from a monomer copolymerizable with the monomers to introduce the structural units M1 and M2,
provided that at least any one of the structural units M1, M2 and A1 has an acid-reactive functional group Y, and contents of the structural units M1, M2 and A1 are from 1 to 99 % by mole, from 1 to 99 % by mole and from 0 to 98 % by mole, respectively, and
the polymer satisfies Equation (X):

$$N_T/(N_C - N_O + 4N_F^2) \leq 2.0 \quad (X)$$

wherein $N_T$ is a compositional average number of whole atoms constituting the fluorine-containing polymer, $N_C$ is a compositional average number of carbon atoms, $N_O$ is a compositional average number of oxygen atoms and $N_F$ is a compositional average number of fluorine atoms bonded to carbon atoms of the polymer trunk chain and bonded to carbon atoms forming an aliphatic ring structure among fluorine atoms which constitute the fluorine-containing polymer (Methods of calculating $N_T$, $N_C$, $N_O$ and $N_F$ are described infra).

It is preferable that the fluorine-containing polymer is a fluorine-containing polymer represented by the formula (2):

$$-(M1)-(M2\text{-}1)-(A1)- \quad (2)$$

wherein the structural unit M2-1 is a structural unit having an aliphatic monocyclic structure in the polymer trunk chain, the structural units M1 and A1 are as defined in the formula (1),
provided that at least any one of the structural units M1, M2-1 and A1 has an acid-reactive functional group Y, and contents of the structural units M1, M2-1 and A1 are from 1 to 99 % by mole, from 1 to 99 % by mole and from 0 to 98 % by mole, respectively.

The fluorine-containing polymer may be a fluorine-containing polymer represented by the formula (3):

$$-(M1)-(M2\text{-}2)-(A1)- \quad (3)$$

wherein the structural unit M2-2 is a structural unit having an aliphatic polycyclic condensed structure in the polymer trunk chain, in which at least one fluorine atom and/or a fluorine-containing alkyl group which has 1 to 10 carbon atoms and may have ether bond is bonded to any of carbon atoms forming the aliphatic ring structure,
the structural units M1 and A1 are as defined in the formula (1),
provided that at least any one of the structural units M1, M2-2 and A1 has an acid-reactive functional group Y, and contents of the structural units M1, M2-2 and A1 are from 1 to 99 % by mole, from 1 to 99 % by mole and from 0 to 98 % by mole, respectively.

It is further preferable that the structural unit M1 is a structural unit which is derived from at least one monomer selected from the group consisting of fluorine-containing ethylenic monomers having 2 or 3 carbon atoms and having at least one fluorine atom bonded to any of carbon atoms forming a trunk chain, particularly at least one monomer selected from the group consisting of tetrafluoroethylene and chlorotrifluoroethylene.

Also it is preferable that each atom of the fluorine-containing polymer satisfies Equation (X2).

$$N_T/(N_C - N_O + 4N_F^2) \leq 1.50 \quad (X2)$$

$F_2$ laser beam, ArF laser beam, KrF laser beam, high energy electron beam, high energy ion beam or X-ray can be used as the energy ray.

The present invention also relates to a method of forming a fine circuit pattern comprising, after forming the fine resist pattern by the above-mentioned method on a substrate or on a given layer on the substrate, a step for forming an intended circuit pattern by etching said substrate or said given layer through the fine resist pattern.

## BRIEF DESCRIPTION OF DRAWINGS

Fig. 1 is a cross-sectional view showing the steps for forming the fine pattern of the present invention.
Fig. 2 is a plotted graph showing a relation between the parameter (X-1) obtained in Example 3 and a dry etching resistance.

## BEST MODE FOR CARRYING OUT THE INVENTION

The present invention is explained below in detail.

As the chemically amplifying resist directed by the present invention, there are a positive type resist and a negative type resist.

Example of the positive type chemically amplifying resist is, for instance, a composition basically containing two components of an alkali-soluble resin to which a group (protective group) having a dissolution-inhibiting effect is introduced, and an acid generator and further containing, as case demands, a dissolution inhibitor. In such a positive type chemically amplifying resist, when the resist is in un-exposed state, solubility thereof in an alkali developing solution is inhibited by a protective group (and further by a dissolution inhibitor).

The photosensitive composition in the present invention basically contains a specific selected fluorine-containing polymer which has high transparency against exposure light having a short wavelength such as $F_2$ laser beam and good dry etching resistance in order to form a precise fine circuit pattern.

First, the fluorine-containing polymer used in the method of forming a fine pattern in the present invention is explained below.

The fluorine-containing polymer used in the method of forming a fine pattern in the present invention is characterized in that the polymer is represented by the formula (1):

$$-(M1)-(M2)-(A1)- \qquad (1)$$

wherein the structural unit M1 is a structural unit derived from a fluorine-containing monomer, in which at least one fluorine atom is bonded to any of carbon atoms forming the polymer trunk chain,
the structural unit M2 is a structural unit having an aliphatic ring structure in the polymer trunk chain,
the structural unit A1 is a structural unit derived from a monomer copolymerizable with the monomers to introduce the structural units M1 and M2,
provided that at least any one of the structural units M1, M2 and A1 has an acid-reactive functional group Y, and contents of the structural units M1, M2 and A1 are from 1 to 99 % by mole, from 1 to 99 % by mole and from 0 to 98 % by mole, respectively, and the polymer satisfies Equation (X):

$$N_T/(N_C - N_O + 4{N_F}^2) \leq 2.0 \qquad (X)$$

wherein $N_T$ is a compositional average number of whole atoms constituting the fluorine-containing polymer, $N_C$ is a compositional average number of carbon atoms, $N_O$ is a compositional average number of oxygen atoms and $N_F$ is a compositional average number of fluorine atoms bonded to carbon atoms of the polymer trunk chain and bonded to carbon atoms forming an aliphatic ring structure among fluorine atoms which constitute the fluorine-containing polymer.

Namely, the fluorine-containing polymer comprises the structural unit M1 having at least one fluorine atom in its trunk chain and the structural unit M2 having a ring structure in its trunk chain as essential components, and has a functional group Y which is dissociated or decomposed by reaction with an acid.

The present inventors have studied dry etching resistance of the fluorine-containing polymer and as a result, have found that the dry etching rate thereof has a good proportional relation with the following parameter (X-1):

$$N_T/(N_C-N_O + 4{N_F}^2) \qquad (X\text{-}1)$$

wherein $N_T$, $N_C$, $N_O$ and ${N_F}^2$ are as defined in Equation (X).

The present inventors have also found that the parameter (X-1) is preferably not more than 2.0, from the viewpoint of dry etching resistance.

It is preferable that the parameter (X-1) satisfies Equation (X1):

$$N_T/(N_C - N_O + 4{N_F}^2) \leq 1.75 \qquad (X1),$$

more preferably Equation (X2):

$$N_T/(N_C - N_O + 4{N_F}^2) \leq 1.50 \qquad (X2).$$

In Equations (X), (X1) and (X2) and the parameter (X-1), $N_T$ represents the number of whole atoms constituting

the polymer.

For example, in the case of the fluorine-containing polymer of the formula (1), $N_T$ can be calculated by (Number of whole atoms in the structural unit M1) × (Molar fraction of M1) + (Number of whole atoms in the structural unit M2) × (Molar fraction of M2) + (Number of whole atoms in the structural unit A1) × (Molar fraction of A1).

$N_C$ and $N_O$ can be calculated in the same manner as above by (Number of carbon atoms in the structural unit M1) × (Molar fraction of M1) + (Number of carbon atoms in the structural unit M2) × (Molar fraction of M2) + (Number of carbon atoms in the structural unit A1) × (Molar fraction of A1) and
(Number of oxygen atoms in the structural unit M1) × (Molar fraction of M1) + (Number of oxygen atoms in the structural unit M2) × (Molar fraction of M2) + (Number of oxygen atoms in the structural unit A1) × (Molar fraction of A1), respectively.

With respect to $N_F$, attention is directed only to the fluorine atoms bonded to the carbon atoms of the polymer trunk chain and bonded to the carbon atoms forming a ring structure, and $N_F$ can be calculated in the same manner as above by (Number of the above fluorine atoms in the structural unit M1) × (Molar fraction of M1) + (Number of the above fluorine atoms in the structural unit M2) × (Molar fraction of M2) + (Number of the above fluorine atoms in the structural unit A1) × (Molar fraction of A1).

Namely, $N_F$ is the sum of fluorine atoms bonded to carbon atoms of linear chain in the polymer trunk chain and fluorine atoms bonded to carbon atoms forming the ring structure. Among the carbon atoms forming the ring structure, there are, for example, carbon atoms forming the ring structure on a side chain or a part of side chain in addition to carbon atoms forming the ring structure on the trunk chain. However fluorine atoms considered in $N_F$ do not include, for example, fluorine atoms bonded to carbon atoms of linear chain which forms a side chain or a part of side chain.

When the above-mentioned equations are satisfied, good dry etching resistance can be exhibited, and on the contrary, if the parameter (X-1) is too large, enough dry etching resistance is not exhibited, which is not preferred.

In the fluorine-containing polymer used in the method of forming a fine pattern of the present invention, as mentioned above, the structural unit M1 is not limited as far as it is derived from a fluorine-containing monomer and has at least one fluorine atom in its trunk chain. Concretely it is preferable that the structural unit M1 is at least one selected from structural units derived from fluorine-containing ethylenic monomers.

For example, there are preferably structural units derived from monomers such as tetrafluoroethylene, chlorotrifluoroethylene, vinylidene fluoride, vinyl fluoride, trifluoroethylene, hexafluoropropylene,

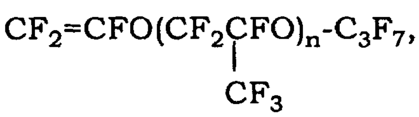 $CF_2{=}CFO{-}(CF_2)_n{-}Z^2$,

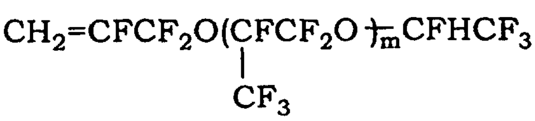 and $CH_2{=}CF{-}(CF_2)_n{-}Z^2$

wherein $Z^2$ is H, Cl or F, n is from 1 to 10, m is from 0 to 10.

It is preferable that the structural unit M1 is at least one selected from structural units derived from fluorine-containing ethylenic monomers having 2 or 3 carbon atoms.

It is particularly preferable that the structural unit M1 is a structural unit derived from tetrafluoroethylene or chlorotrifluoroethylene, from the viewpoint of good transparency and dry etching resistance.

Other examples are structural units derived from fluorine-containing acryl derivatives.

There are concretely structural units represented by the following formula:

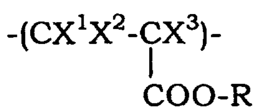

wherein $X^1$ and $X^2$ are the same or different and each is H or F; $X^3$ is H, Cl, $CH_3$, F or $CF_3$; R is hydrogen atom, a hydrocarbon group having 1 to 20 carbon atoms, a fluorine-containing alkyl group having 1 to 20 carbon atoms, a

fluorine-containing alkyl group which has 2 to 100 carbon atoms and ether bond or a fluorine-containing aryl group having 3 to 20 carbon atoms; at least one of $X^1$, $X^2$ and $X^3$ is fluorine atom or $X^3$ is $CF_3$. Preferred are structural units derived from αfluoroacryl derivatives.

Concretely there are the following monomers.

$$CH_2=CFCOOC(CH_3)_3,\ CH_2=CFCOOCH_2CH_2OH,$$

$$CF_2=C(CF_3)COOC(CH_3)_3,$$

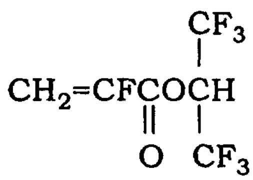 , 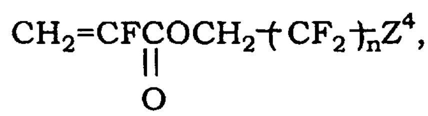

($Z^4$: H, F or Cl, n: 1 to 10)

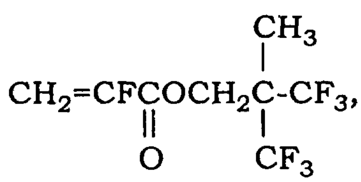 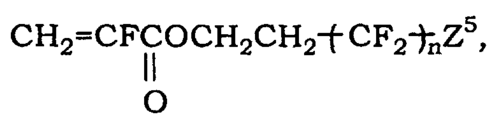

($Z^5$: H, F or Cl, n: 1 to 10)

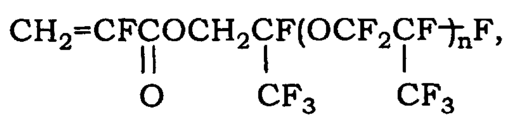

(n: 1 to 5)

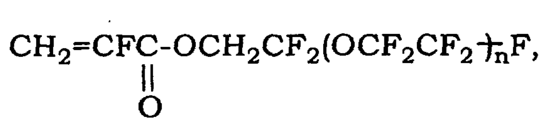

(n: 1 to 30)

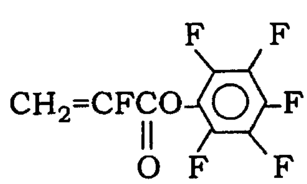

Also a structural unit derived from a fluorine-containing ethylenic monomer having an acid-reactive functional group Y necessary for a resist or other functional group may be used as the structural unit M1. Examples of the structural unit having the acid-reactive functional group Y are, for instance, structural units represented by:

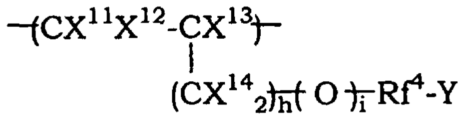

wherein $X^{11}$, $X^{12}$ and $X^{13}$ are H or F and at least one of them is F; $X^{14}$ is H, F or $CF_3$; h is 0, 1 or 2; i is 0 or 1; $Rf^4$ is a fluorine-containing alkylene group having 1 to 40 carbon atoms or a fluorine-containing alkylene group having 2 to 100 carbon atoms and ether bond; Y is an acid-reactive functional group,
and a structural unit represented by:

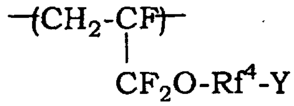

is particularly preferred. Hereinafter Y represents an acid-reactive group and is not noted particularly.

Concretely preferred are structural units derived from fluorine-containing ethylenic monomers such as:

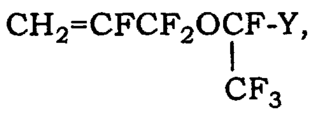, 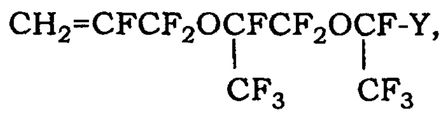,

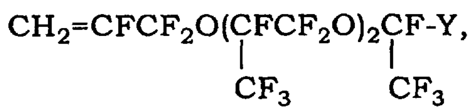,

$CH_2=CFCF_2OCH_2CF_2\text{-}Y$,

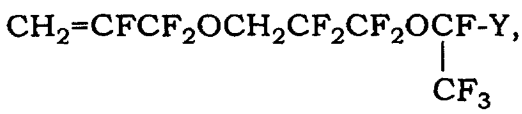,

$CH_2=CFCF_2OCF_2CF_2OCF_2\text{-}Y$

and

$CH_2=CFCF_2O(CF_2CF_2O)_2CF_2\text{-}Y$.

Also there are preferably structural units represented by the formula:

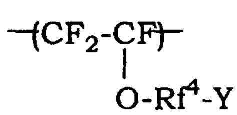

wherein $Rf^4$ is as defined above.

Concretely there are structural units derived from monomers such as:

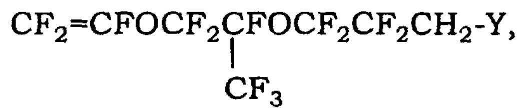

$CF_2=CFO(CF_2)_3Y$, $CF_2=CFO-(CF_2)_3CH_2-Y$,

$CF_2=CFOCF_2CF_2OCF_2-Y$,

$CF_2=CFOCF_2CF_2OCF_2CH_2-Y$,

$CF_2=CFOCF_2CF_2CH_2OCF_2CF_2-Y$,

$CF_2=CFOCF_2CF_2CH_2OCF_2CF_2CH_2-Y$

and

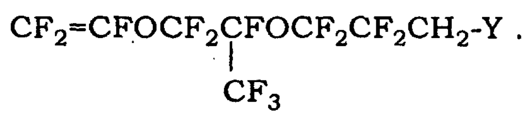

Also there are other fluorine-containing ethylenic monomers having functional group such as:

$CF_2=CFCF_2-O-Rf^4-Y$ and $CF_2=CF-Rf^4-Y$

wherein $Rf^4$ is as defined above.

Concretely there are:

$CF_2=CFCF_2OCF_2CF_2CF_2-Y$,

$CF_2=CFCF_2OCF_2CF_2CF_2CH_2-Y$,

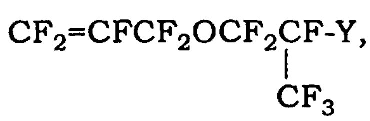 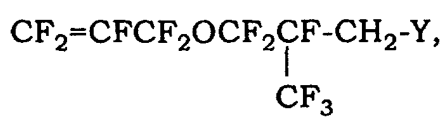

$CF_2=CFCF_2-Y$, $CF_2=CFCF_2CH_2-Y$,

and the like.

In the fluorine-containing polymer which is used for the method of forming a fine pattern in the present invention, the structural unit M2 is the above-mentioned structural unit of an aliphatic ring structure having a ring structure in its trunk chain, and may have or may not have fluorine atom. Also the structural unit M2 may have an acid-reactive

functional group Y necessary for a resist and further other functional group.

The first of preferred structural unit M2 is a structural unit represented by the structural unit M2-1 and having an aliphatic monocyclic structure in the polymer trunk chain.

Examples of the preferred structural unit M2-1 are, for instance, derived from monomers such as:

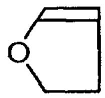 , 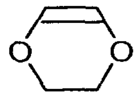 , 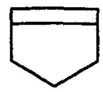 , 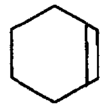 ,

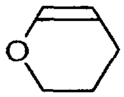 , 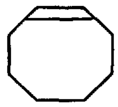 , 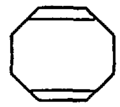 , 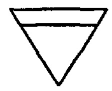 and 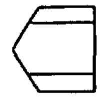 .

Also examples of the structural unit having an acid-reactive functional group Y are those derived from monomers such as:

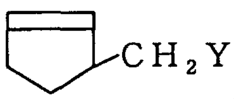 , 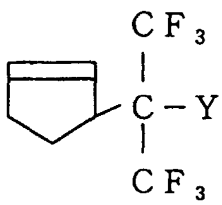 , 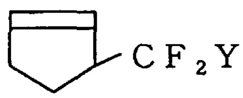 ,

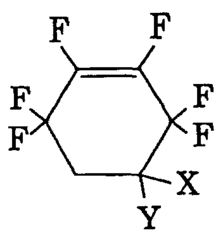 , 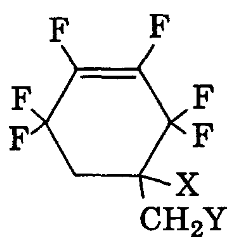 ,

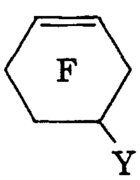 , 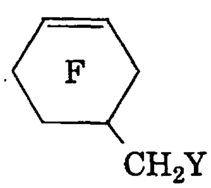 and 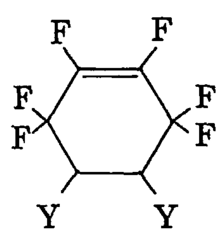

wherein X is H, F, $CF_3$ or $CH_3$.

Those structural units having an aliphatic monocyclic hydrocarbon are insufficient in dry etching resistance in the case of sole use thereof, but when the above-mentioned structural unit M1 having fluorine atom in its trunk chain is so copolymerized that the above-mentioned equation is satisfied, unexpectedly dry etching resistance is enhanced remarkably.

Namely, it was found that even if M2 is a monocyclic structural unit, when many fluorine atoms are introduced to the structural unit M1, dry etching resistance higher than that in the case of use of an aliphatic hydrocarbon having

polycyclic condensed structure could be obtained.

As a result, transparency can also be enhanced more.

Also the structural unit M2-1 may have fluorine atom on carbon atom forming a ring structure. For example, in the structural unit M2-1, hydrogen atoms of only a part of carbon atoms forming the aliphatic monocyclic structures exemplified above may be substituted with fluorine atoms.

Further in the structural unit M2-1, all hydrogen atoms of all carbon atoms forming the ring may be substituted with fluorine atoms or only a part of hydrogen atoms may be left and all the other remaining hydrogen atoms may be substituted with fluorine atoms.

Examples of the preferred structural unit M2-1 are those represented by:

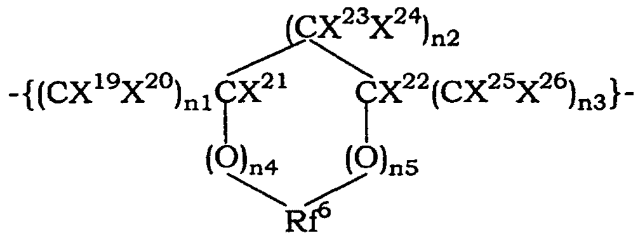

wherein $X^{19}$, $X^{20}$, $X^{23}$, $X^{24}$, $X^{25}$ and $X^{26}$ are the same or different and each is H or F; $X^{21}$ and $X^{22}$ are the same or different and each is H, F, Cl or $CF_3$; $Rf^6$ is a fluorine-containing alkylene group having 1 to 10 carbon atoms or a fluorine-containing alkylene group having 2 to 10 carbon atoms and ether bond; n2 is 0 or an integer of from 1 to 3; n1, n3, n4 and n5 are the same or different and each is 0 or 1.

For example, there are structural units represented by:

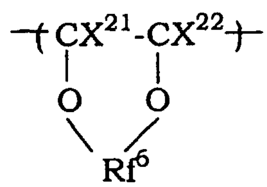

wherein $Rf^6$, $X^{21}$ and $X^{22}$ are as defined above.

Concretely there are:

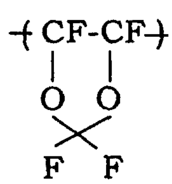 , 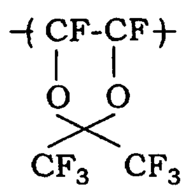 , 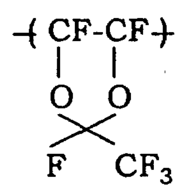 ,

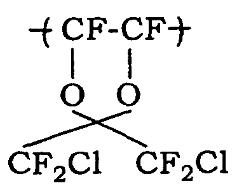 , 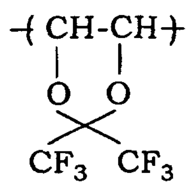 , 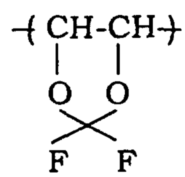 ,

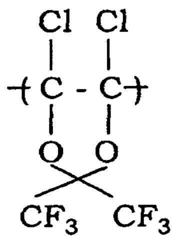 , 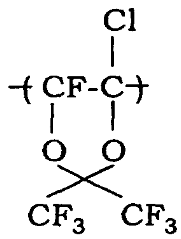 , 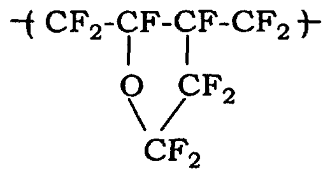 ,

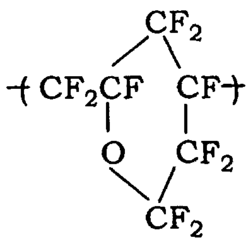 , 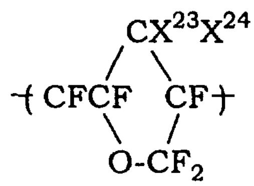 ,

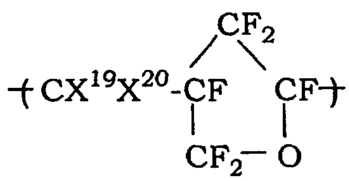 , 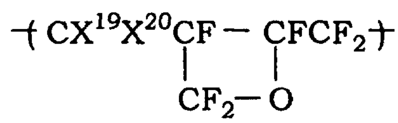 ,

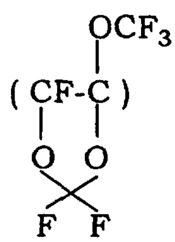 , 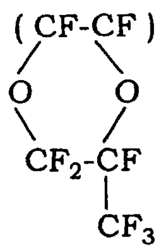

and the like, wherein $X^{19}$, $X^{20}$, $X^{23}$ and $X^{24}$ are as defined above.

Other examples are structural units derived from monomers:

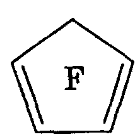 , 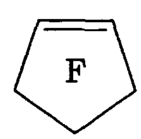

and the like.

Those structural units are preferred because transparency can be enhanced by introducing fluorine atoms to the ring structure without lowering dry etching resistance.

However as a result of studies by the present inventors, even if the monocyclic structural unit is a monocyclic hydrocarbon having no fluorine atom on carbon atoms forming a ring structure, when the above-mentioned equation is satisfied, the polymer has enough dry etching resistance and transparency and is preferred more as a polymer for a resist from the viewpoint of practicality.

The second of preferred structural unit M2 are structural units represented by the structural unit M2-2 and having an aliphatic polycyclic condensed structure in the polymer trunk chain. In those structural units, at least one fluorine atom and/ or a fluorine-containing alkyl group which has 1 to 10 carbon atoms and may have ether bond is bonded to any of carbon atoms forming a ring structure.

In an aliphatic polycyclic condensed structure, there was a problem with transparency though it had good dry etching resistance. The present inventors have found that by introducing fluorine atoms to the ring structure, transparency could be improved without lowering dry etching resistance.

Examples thereof are concretely structural units derived from norbornene derivatives represented by the formula:

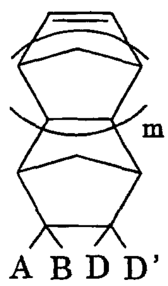

wherein A, B, D and D' are the same or different and each is H, F, an alkyl group having 1 to 10 carbon atoms or a fluorine-containing alkyl group having 1 to 10 carbon atoms; m is 0 or an integer of from 1 to 3, any one of A, B D and D' has fluorine atom.

Examples thereof are structural units derived from norbornene derivatives represented by:

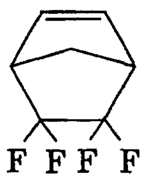 , 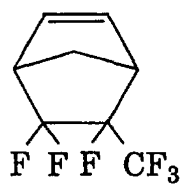 , 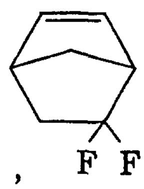 , 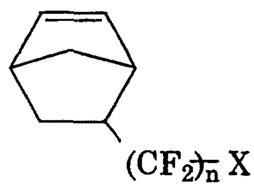 ,

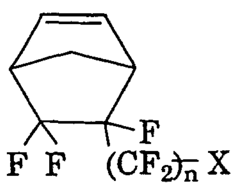 , 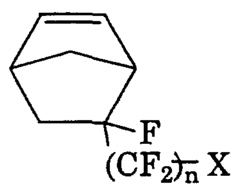 (n: from 1 to 10, X: H, F or Cl)

and the like.

In addition, there are structural units derived from the monomers:

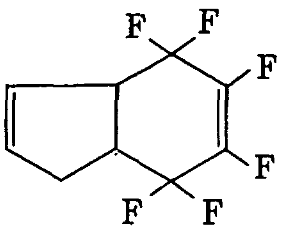
,
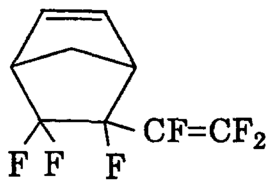
,
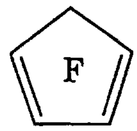
,
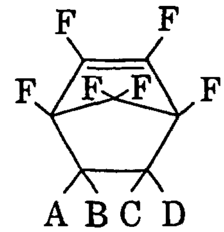
,

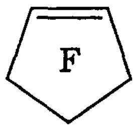

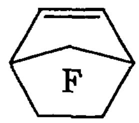

(A, B, D and D' are H, F, an alkyl group or fluorine-containing alkyl group having 1 to 10 carbon atoms)

and the like.

Among them, preferred are structural units derived from norbornene derivatives.

The structural unit M2-2 may be those having a functional group, particularly an acid-reactive functional group Y necessary for a resist. Examples thereof are structural units derived from:

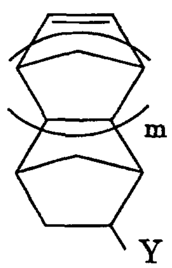
,
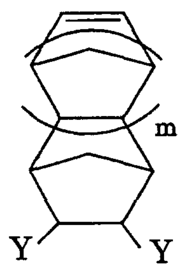

(m is 0 or an integer of 1 to 3),

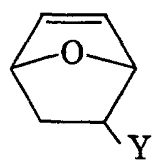

and the like.

Further a part of or the whole of hydrogen atoms of the structural unit M2-2 may be substituted with fluorine atoms, which is preferred because higher transparency can be imparted to the polymer.

Examples thereof are structural units derived from fluorine-containing norbornene derivatives represented by the formula:

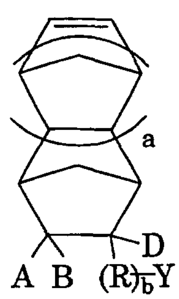

wherein A, B and D are the same or different and each is H, F, an alkyl group having 1 to 10 carbon atoms or a fluorine-containing alkyl group which has 1 to 10 carbon atoms and may have ether bond; R is a divalent hydrocarbon group having 1 to 20 carbon atoms, a fluorine-containing alkylene group having 1 to 20 carbon atoms or a fluorine-containing alkylene group having 2 to 100 carbon atoms and ether bond; a is 0 or an integer of from 1 to 5; b is 0 or 1; when b is 0 or R does not have fluorine atom, any one of A, B and D is fluorine atom or a fluorine-containing alkyl group which may have ether bond.

It is preferable that any of A, B and D is fluorine atom, or when fluorine atom is not contained in A, B and D, a fluorine content of R is not less than 60 %. Further it is preferable that R is a perfluoroalkylene group, because transparency can be imparted to the polymer.

Examples thereof are structural units derived from norbornene derivatives represented by:

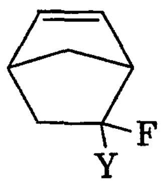 , 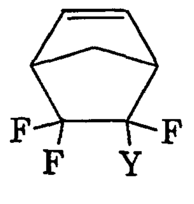 , 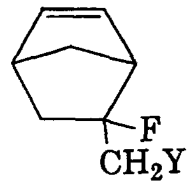 , 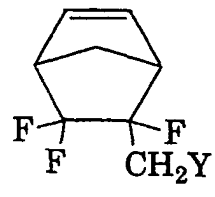 ,

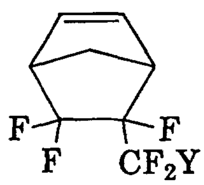 , 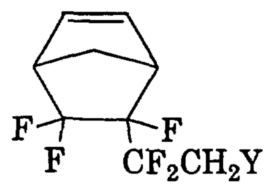 , 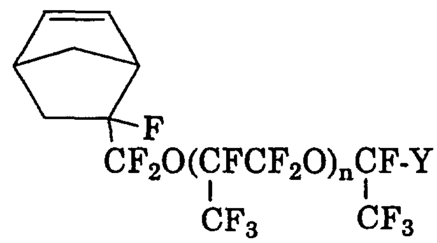 ,

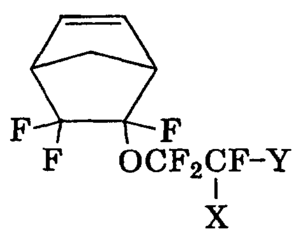 , 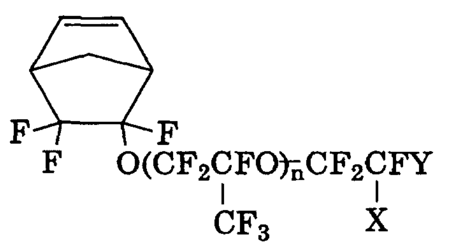 ,

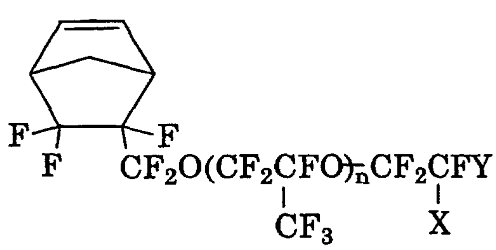

and the like, wherein n is from 0 to 10, X is F or $CF_3$, and the like.

Also there are fluorine-containing monomers represented by

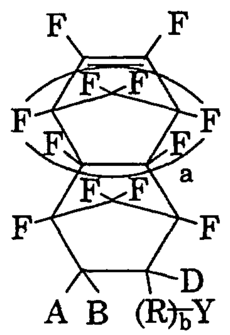

wherein A, B and D are the same or different and each is H, F, an alkyl group having 1 to 10 carbon atoms or a fluorine-containing alkyl group which has 1 to 10 carbon atoms and may have ether bond; R is a divalent hydrocarbon group having 1 to 20 carbon atoms, a fluorine-containing alkylene group having 1 to 20 carbon atoms or a fluorine-containing alkylene group having 2 to 100 carbon atoms and ether bond; a is 0 or an integer of from 1 to 5; b is 0 or 1.

Examples thereof are those having a norbornene backbone such as:

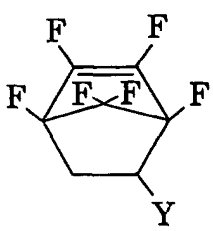 , 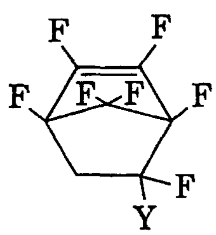 , 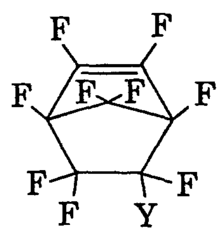 ,

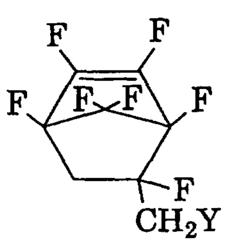 , 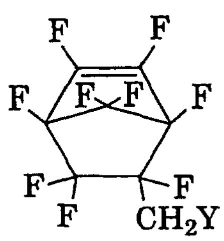 , 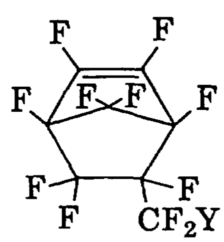 ,

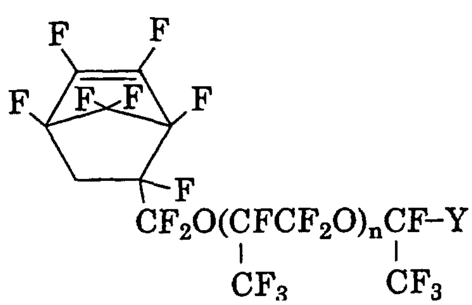 ,

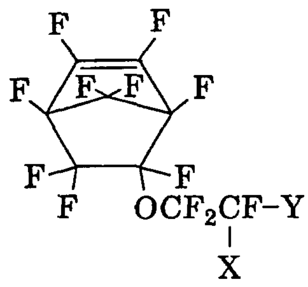

,

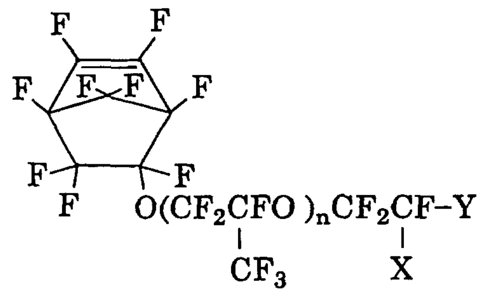

and

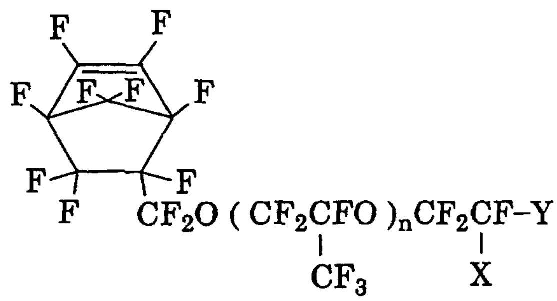

wherein X is F or $CF_3$, n is 0 to 10.

It is preferable that the structural unit M2-2 having an acid-reactive functional group Y necessary for a resist is a structural unit derived from at least one selected from fluorine-containing norbornene derivatives represented by the following formula:

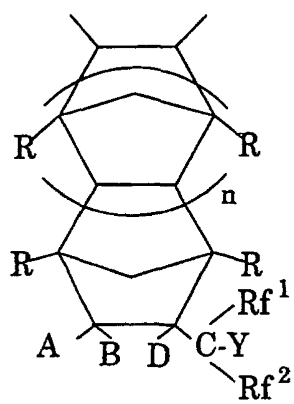

wherein $Rf^1$ and $Rf^2$ are the same or different and each is a fluorine-containing alkyl group having 1 to 10 carbon atoms or a fluorine-containing alkyl group having 1 to 10 carbon atoms and ether bond; A, B and D are the same or different and each is H, F, Cl, an alkyl group having 1 to 10 carbon atoms or a fluorine-containing alkyl group which has 1 to 10 carbon atoms and may have ether bond; R is H or an alkyl group having 1 to 10 carbon atoms; n is 0 or an integer of from 1 to 5; at least one of A, B and D is F or a fluorine-containing alkyl group which has 1 to 10 carbon atoms and may have ether bond

Examples thereof are, for instance;

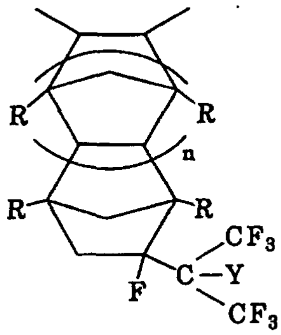,
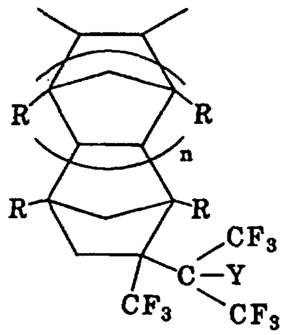,
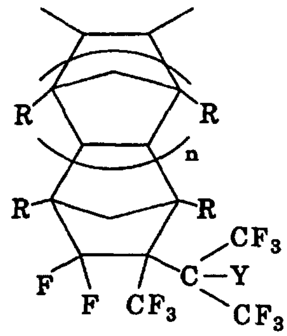,

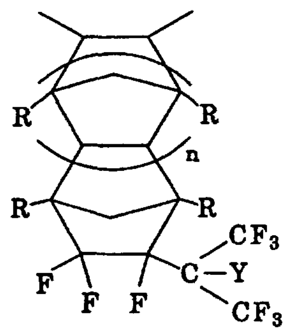,
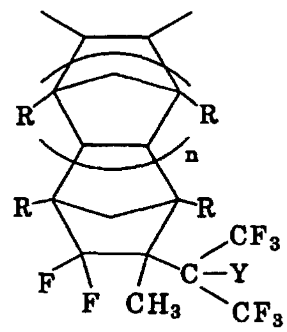,
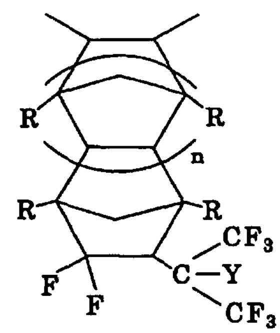,

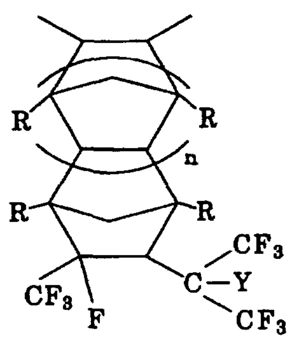,
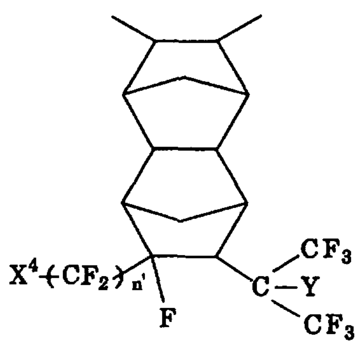

and the like, wherein $X^4$ is H, F or Cl; n is from 0 to 5, n' is from 1 to 10; R is H or an alkyl group having 1 to 10 carbon atoms.

Preferred examples thereof are:

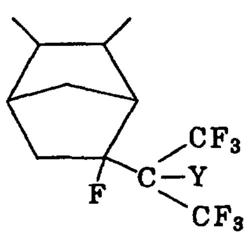,
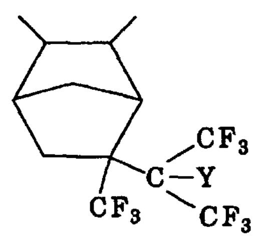,
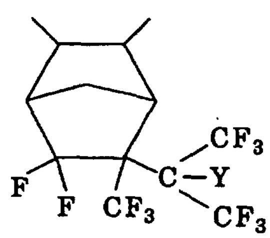,

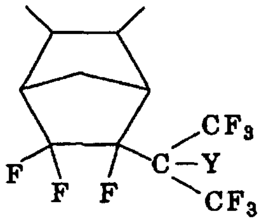,
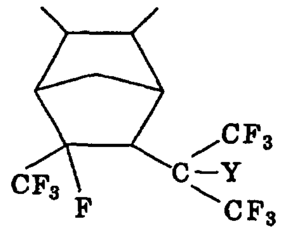,
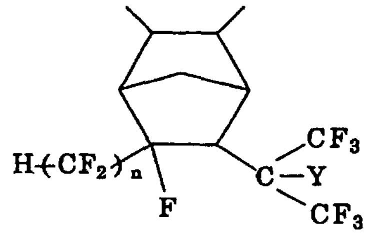

and the like, wherein n is from 1 to 10.

In the fluorine-containing polymer which is used for the method of forming a fine pattern of the present invention, the structural unit A1 is an optional component and is a structural unit derived from a monomer copolymerizable with monomers introducing the above-mentioned structural unit M1 and/or M2.

The structural unit A1 may have fluorine atom and may have an acid-reactive functional group Y necessary for a resist and other functional groups.

Examples thereof are, for instance, the following structural units.

(i) Structural unit derived from acrylic monomer (which is not included in the above-mentioned M1)

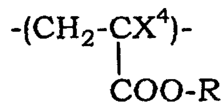

wherein $X^4$ is H, Cl, $CH_3$ or $CF_3$; R is a hydrocarbon group having 1 to 20 carbon atoms, a fluorine-containing alkyl group having 1 to 20 carbon atoms, a fluorine-containing alkyl group having 2 to 100 carbon atoms and ether bond or a fluorine-containing aryl group having 3 to 20 carbon atoms.

In the above formula, examples of preferred -R are:

$$-C(CH_3)_3,\ -CH_2CH_2OH,\ -(CH_2)_m(CF_2)_n\text{-}F,\ -(CH_2)_m(CF_2)_n\text{-}H,$$

$$-(CH_2)_m(CF_2)_n\text{-}Cl,\ -CH(CF_3)_2,\ -CH_2CFHCF_3,\ -(CH_2)_m(CF_2)_n\text{-}CF(CF_3)_2,$$

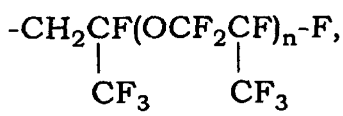

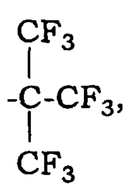, 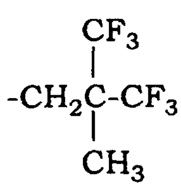

and the like, wherein m is an integer of from 1 to 5, n is an integer of from 1 to 10.

Examples thereof are, for instance, acrylic acid, methacrylic acid, acrylic acid esters, methacrylic acid esters, maleic anhydride, maleic acid, maleic acid esters, hydroxyethyl acrylate, hydroxyethyl methacrylate, glycidyl acrylate, glycidyl methacrylate and the like.

Introduction of the structural unit derived therefrom is preferred because solubility in a solvent, photosensitivity through a photoacid generator, adhesion to a substrate and compatibility with a photoacid generator and other additives

can be enhanced.

(ii) Structural unit derived from a fluorine-containing ethylenic monomer having functional group (which is not included in the above-mentioned M1)

For example, there are $CH_2$=CH-$Rf^4$-Y, $CH_2$=CHO-$Rf^4$-Y and the like, wherein $Rf^4$ is a fluorine-containing alkylene group having 1 to 40 carbon atoms or a fluorine-containing alkylene group having 2 to 100 carbon atoms and ether bond, and concretely there are:

$CH_2=CHCF_2CF_2CH_2CH_2$-Y, $CH_2=CHCF_2CF_2$-Y,

$CH_2=CHCF_2CF_2CH_2$-Y, $CH_2=CHCF_2CF_2CF_2CF_2$-Y,

$CH_2=CHCF_2CF_2CF_2CF_2CH_2$-Y, $CH_2=CHO-CH_2CF_2CF_2$-Y,

$CH_2=CHOCH_2CF_2CF_2CH_2$-Y

and the like.

(iii) Structural unit derived from an ethylenic monomer having no fluorine

The structural units derived from ethylenic monomers having no fluorine may be introduced to the polymer within a range where the introduction does not have an adverse effect on transparency and dry etching resistance.
The introduction of these structural units is preferred since adhesion to a substrate is improved, solubility in a general-purpose solvent is enhanced and compatibility with, for example, a photoacid generator and additives to be added as case demands can be improved.
Examples of the non-fluorine-containing ethylenic monomer are as follows.

α-Olefins:

Ethylene, propylene, butene, vinyl chloride, vinylidene chloride and the like.

Vinyl ether or vinyl ester monomers:

$CH_2$=CHOR, $CH_2$=CHOCOR (R: hydrocarbon group having 1 to 20 carbon atoms) and the like.

Allyl monomers:

$CH_2=CHCH_2Cl$, $CH_2=CHCH_2OH$, $CH_2=CHCH_2COOH$,

$CH_2=CHCH_2Br$ and the like.

Allyl ether monomers:

$CH_2=CHCH_2OR$

(R: hydrocarbon group having 1 to 20 carbon atoms),

$CH_2=CHCH_2OCH_2CH_2COOH$ ,

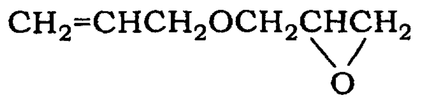 , 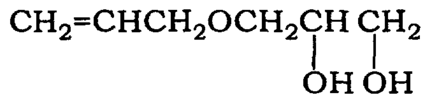

and the like.

The fluorine-containing polymer which is used for the method of forming a fine pattern of the present invention is one having an acid-reactive functional group Y necessary for a chemically amplifying resist. Examples thereof are those having at least one of a functional group $Y^1$ which can make the polymer soluble in an aqueous solution of tetramethylammonium hydroxide which is an alkaline developing solution or a functional group $Y^2$-P (P is also called a protective group) which is converted to $Y^1$ by dissociation or decomposition due to reaction with an acid generated from an acid-generator in a resist composition, or preferably those having both of $Y^1$ and $Y^2$-P.

The functional group $Y^1$ which can make the polymer soluble in a developing solution is selected concretely from -OH group and -COOH group. Particularly -OH group is selected from those having high acidity. Concretely selected -OH group is represented by the structure including neighboring structure:

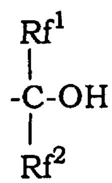 , 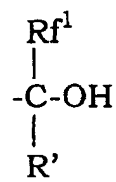

wherein $Rf^1$ and $Rf^2$ are the same or different and each is a fluorine-containing alkyl group having 1 to 10 carbon atoms or a fluorine-containing alkyl group having 1 to 10 carbon atoms and ether bond; R' is H or a hydrocarbon group having 1 to 10 carbon atoms. This structure is preferable from the viewpoint of transparency.

The acid-reactive functional group $Y^2$-P in which a protective group is bonded has a function of making the polymer insoluble in an alkaline developing solution and is converted to $Y^1$, namely -OH group or -COOH group due to reaction with an acid.

Among the acid-reactive functional groups $Y^2$-P in which a protective group is bonded, examples of the acid-reactive functional group $Y^2$-P (namely, -O-P) which is converted to -OH group due to reaction with an acid are preferably groups represented by:

$-OC(R^1)_3$ , $-OCH_2OR^2$ , 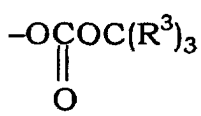 , 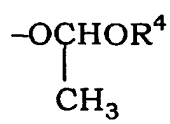

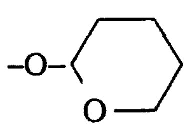

and

wherein $R^1$, $R^2$, $R^3$ and $R^4$ are the same or different and each is an alkyl group having 1 to 5 carbon atoms.

More concretely there are:

$-OC(CH_3)_3$ , $-OCH_2OCH_3$, $-OCH_2OC_2H_5$,

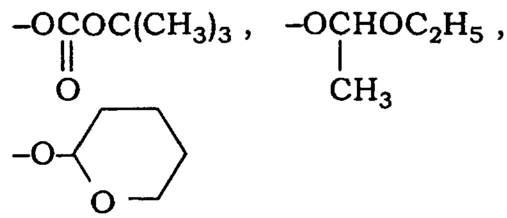

and the like. Among them, more preferable examples are $-OC(CH_3)_3$,

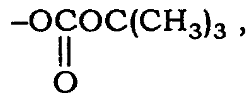

$-OCH_2OCH_3$ and $-OCH_2OC_2H_5$

from the viewpoint of good acid reactivity and further from the viewpoint of good transparency, preferred are $-OC(CH_3)_3$, $-OCH_2OCH_3$ and $-OCH_2OC_2H_5$.

Examples of $Y^2$-P (namely, -COO-P) which is converted to -COOH group due to reaction with an acid are:

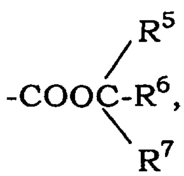 , 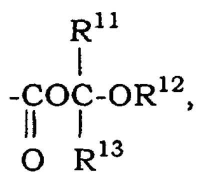 , 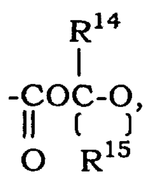 , 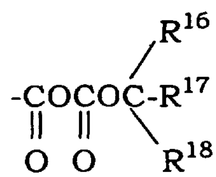

and the like, wherein $R^5$, $R^6$, $R^7$, $R^8$, $R^9$, $R^{10}$, $R^{12}$, $R^{13}$, $R^{16}$, $R^{17}$ and $R^{18}$ are the same or different and each is a hydrocarbon group having 1 to 10 carbon atoms; $R^{11}$ and $R^{14}$ are the same or different and each is H or a hydrocarbon group having 1 to 10 carbon atoms; $R^{15}$ is a divalent hydrocarbon group having 2 to 10 carbon atoms. Preferred examples thereof are:

$-COOC(CH_3)_3$,

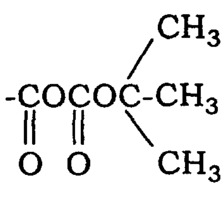 , 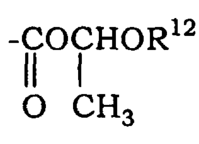 , 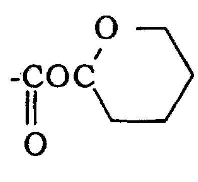

and the like, wherein $R^{12}$ is an alkyl group having 1 to 10 carbon atoms.

The fluorine-containing polymer which is used for the method of forming a fine pattern of the present invention is one having at least one of the above-mentioned -OH group, -COOH group, -O-P group having a protective group and -COO-P group having a protective group as an acid-reactive group Y. It is preferable that -OH group and protected -O-P group, -COOH group and protected -COO-P group, and -OH group and -COO-P group coexist, respectively.

A content of the acid-reactive group Y (sum of the above-mentioned functional groups) varies depending on a polymer backbone and kind of functional group, and is from 5 to 80 % by mole, preferably from 20 to 70 % by mole, more preferably from 30 to 60 % by mole based on the whole structural units. If the content is too small, solubility in a developing solution becomes insufficient and resolution becomes insufficient, which is not preferable. If the content is too large, transparency and dry etching resistance are lowered, which is also not preferable.

Next, an acid generator for the photosensitive composition which is used for the method of forming a fine pattern of the present invention is explained below.

In the photosensitive composition used in the present invention, for example, optional compounds which generate an acid by irradiation of light having a short wavelength such as $F_2$ laser beam, high energy electron beam, ion beam, X-ray or the like or a mixture of those compounds can be used as a compound (acid generator) generating an acid by irradiation of energy rays.

Examples of the compound (acid generator) generating an acid by irradiation of energy rays are, for instance, salts such as diazonium salt, phosphonium salt, sulfonium salt, iodonium salt, $CF_3SO_3$, p-$CH_3PhSO_3$ and p-$NO_2PhSO_3$ (Ph represents phenyl), organic halides, orthoquinone-diadidosulfonyl chloride, sulfonic acid ester and the like.

The above-mentioned organic halides are compounds forming hydrohalogenic acids. Examples thereof are those disclosed in USP3,515,551, USP3,536,489, USP3,779,778, DE Patent Publication 2,243,621, etc.

Other compounds generating an acid by irradiation of light mentioned above are disclosed in JP54-74728A, JP55-24113A, JP55-77742A, JP60-3626A, JP60-138539, JP56-17345A and JP56-36209A.

Examples of those compounds are di(p-tertiarybutyl phenyl)iodonium trifluoromethane sulfonate, diphenyliodonium trifluoromethane sulfonate, benzoin tosilate, orthonitrobenzylparatoluene sulfonate, triphenylsulfonium trifluoromethane sulfonate, tri(tertiarybutyl phenyl)sulfonium trifluoromethane sulfonate, benzenediazonium paratoluene sulfonate, 4-(di-n-propylamino)-benzonium tetrafluoroborate, 4-p-tolyl-mercapto-2,5-diethoxy-benzenediazonium hexafluorophosphate, tetrafluoroborate, diphenylamine-4-diazoniumsulfate, 4-methyl-6-trichloromethyl-2-pyrone, 4-(3,4,5-trimethoxy-styryl)-6-trichloromethyl-2-pyrone, 4-(4-methoxy-styryl)-6-(3,3,3-trichloro-propenyl)-2-pyrone, 2-trichloromethyl-benzoimidazole, 2-tribromomethyl-quinoline, 2,4-dimethyl-1-tribromoacetyl-benzene, 4-dibromoacetyl benzoate, 1,4-bis-dibromomethyl-benzene, tris-dibromomethyl-s-triazine, 2-(6-methoxy-naphtyl-2-yl)-4,6-bis-trichloromethyl-s-triazine, 2-(naphtyl-1-yl)-4,6-bis-trichloromethyl-s-triazine, 2-(naphtyl-2-yl)-4,6-bis-trichloromethyl-s-triazine, 2-(4-ethoxyethyl-naphtyl-1-yl)-4,6-bis-trichloromethyl-s-triazine, 2-(benzopyrani-3-yl)-4,6-bis-trichloromethyl-s-triazine, 2-(4-methoxy-anthrasi-1-yl)-4,6-bis-trichloromethyl-s-triazine, 2-(phenanthi-9-yl)-4,6-bis-trichloromethyl-s-triazine, o-naphthoquinonediazide-4-sulfonic acid chloride, and the like. Examples of sulfonic acid ester are naphthoquinonediazide-4-sulfonic acid ester, naphthoquinonediazide-5-sulfonic acid ester, p-toluenesulfonate-2,6-dinitrobenzyl ester and the like.

It is particularly preferable to use o-quinonediazide compound as the above-mentioned compound (acid generator) generating an acid by irradiation of chemical radiation. The above-mentioned o-quinonediazide compound is not limited particularly, and an ester of o-quinonediazide sulfonate and phenol compound is preferred. The ester of o-quinonediazide sulfonate and phenol compound can be prepared through known method by reacting o-quinonediazide sulfonic acid chloride with a phenol compound.

For example, 1-benzophenone-2-diazo-4-sulfonic acid chloride, 1-naphthoquinone-2-diazo-5-sulfonic acid chloride, 1-naphthoquinone-2-diazo-4-sulfonic acid chloride or the like can be used as the above-mentioned o-quinonediazide sulfonic acid chloride.

Examples of the phenol compound which can be used are, for instance, phenol, cresol, xylenol, bisphenol A, bisphenol S, hydroxybenzophenone, 3,3,3',3'-tetramethyl-1,1'-spirobinda-5,6,7,5',6',7'-hexanol, phenolphthalein, dimethyl p-hydroxybenzylidene malonate, dinitrile p-hydroxybenzylidene malonate, cyanophenol, nitrophenol, nitrosophenol, hydroxyacetophenone, methyl trihydroxybenzoate, polyvinylphenol, novolac resin and the like. Examples of the o-quinonediazide compounds are those represented by the following formulae (3) to (7).

Formula (3):

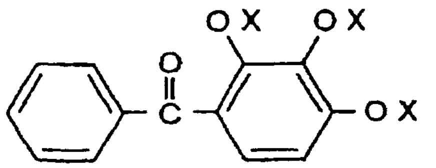
,
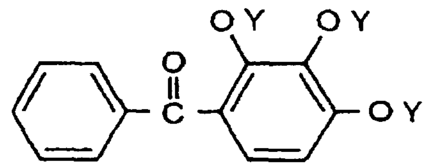
,
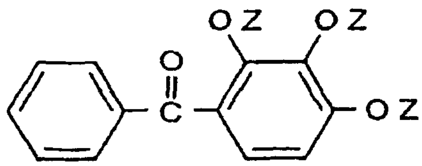
,
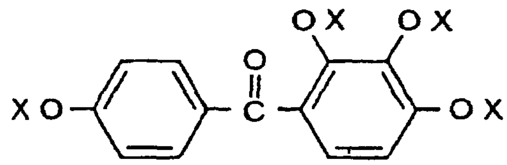
,
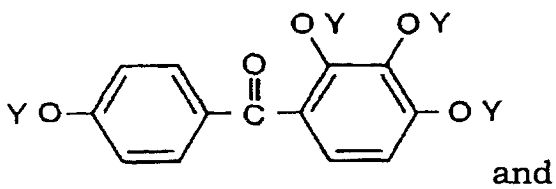
and
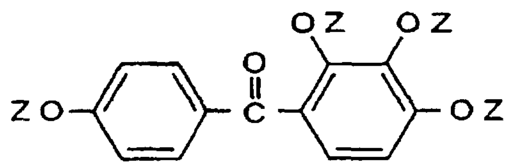

In the above-mentioned formulae,

X represents:

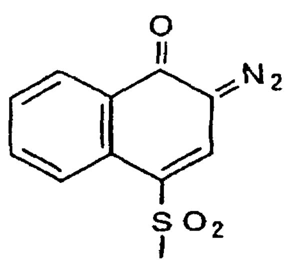
,

Y represents:

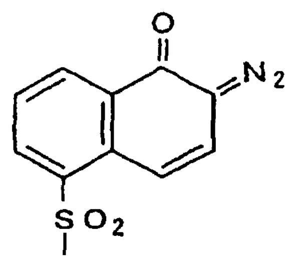

and

Z represents:

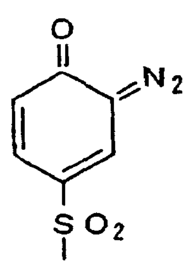

Formula (4):

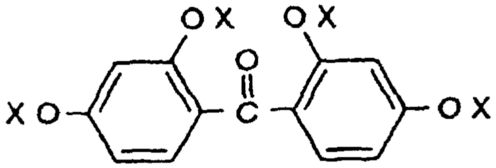

,

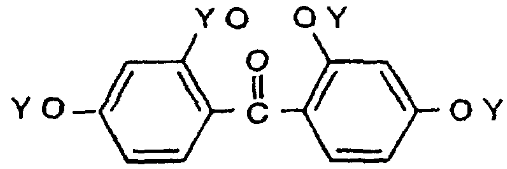

,

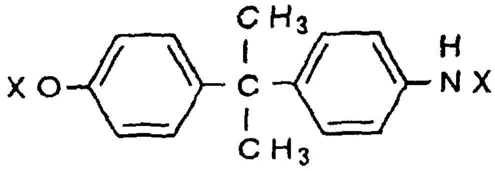

,

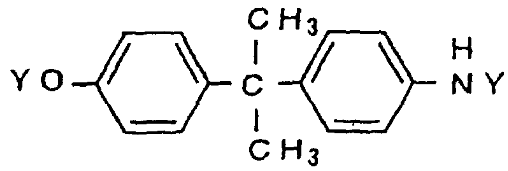

,

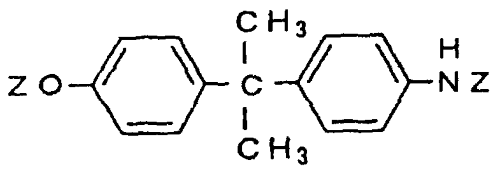

and

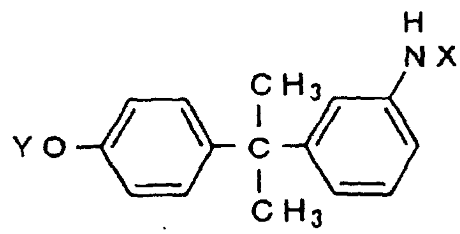

In the above-mentioned formulae,

X represents:

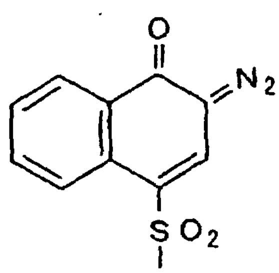

,

Y represents:

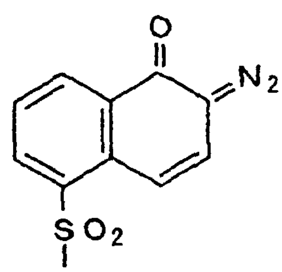

and

Z represents:

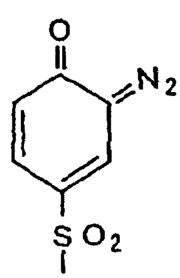

Formula (4):

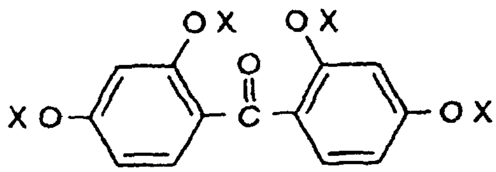

,

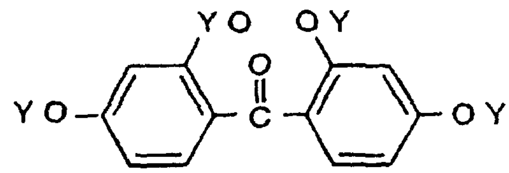

,

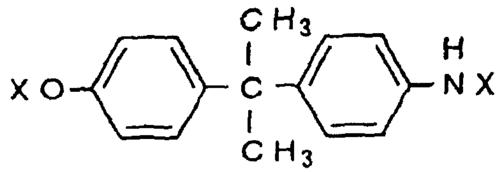

,

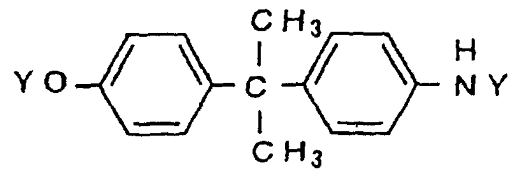

,

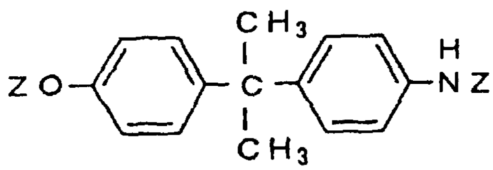

and

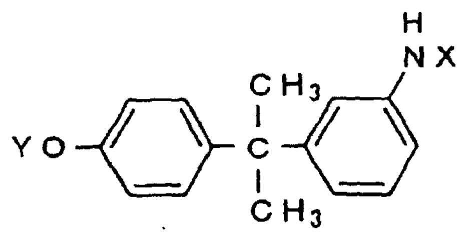

In the above-mentioned formulae,
X represents:

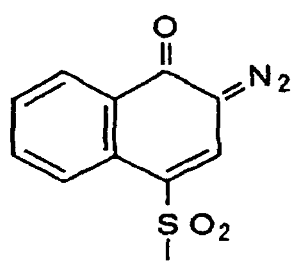

Formula (5):

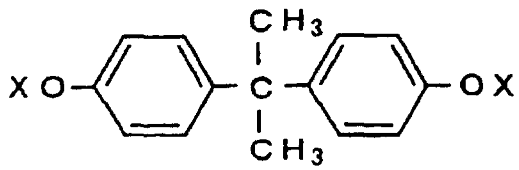

,

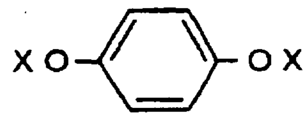

,

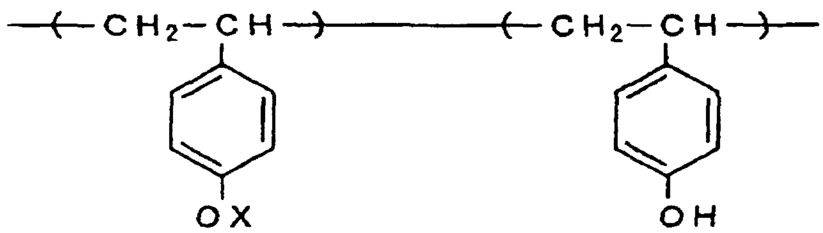

and

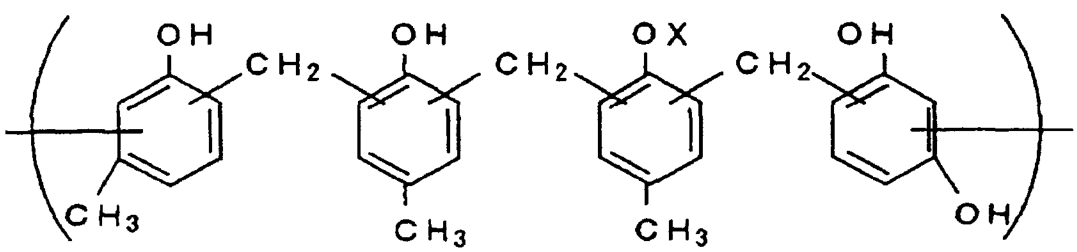

In the above-mentioned formulae,
X represents:

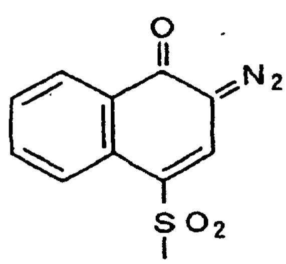

Formula (6):

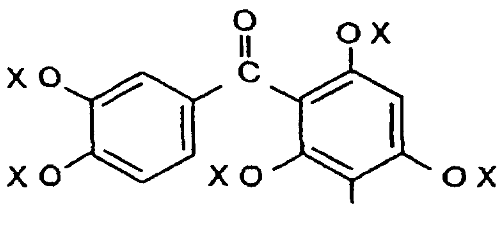
,
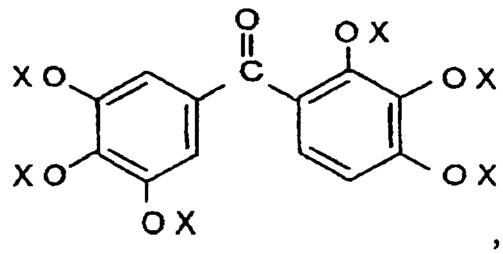
,
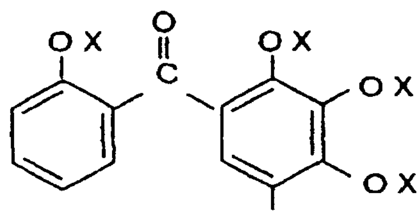
,
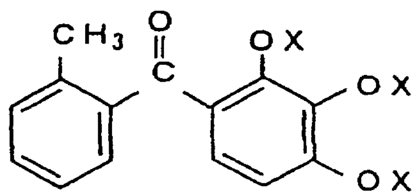
,
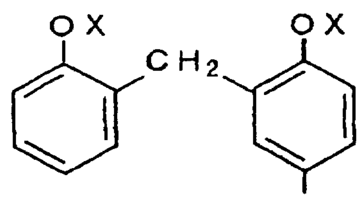
and
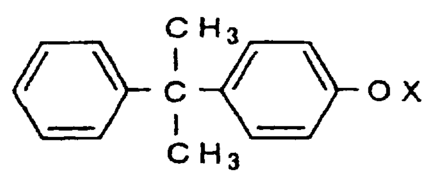

In the above-mentioned formulae,

X represents: and Y represents:

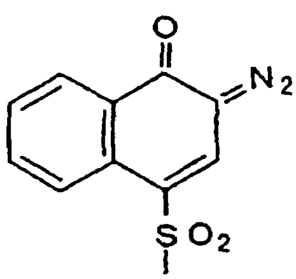

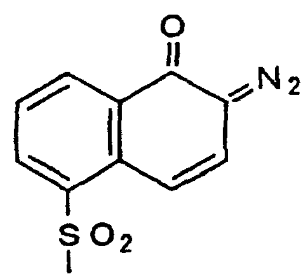

Among the above-mentioned o-quinonediazide compounds, particularly 1-naphthoquinone-2-diazo-4-sulfonic acid ester is suitable. It is known that such an ester generates, by irradiation of light, carboxylic acid and sulfonic acid which is an acid stronger than carboxylic acid as disclosed in J. J. Grimwaid, C. Gal, S. Eidelman, SPIE Vol. 1262, Advances in Resist Technology and Processing VII, p444 (1990), and the ester is particularly effective because of its large catalytic action.

As the above-mentioned compound (acid-generator) which generates an acid by irradiation of chemical radiation, there can be suitably used the compounds (A-1), (A-2) and (A-3) represented by the following formulae (8), (9) and (10), respectively.

Formula (8):

Formula (A-1)

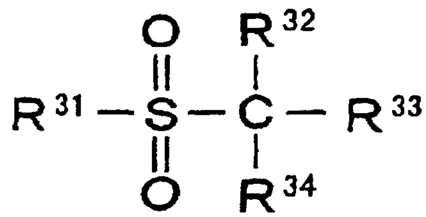

In the above formula (A-1), $R^{31}$ represents a monovalent organic group or a monovalent organic group to which at least one selected from the group consisting of halogen atom, nitro group and cyano group is introduced, $R^{32}$, $R^{33}$ and $R^{34}$ independently represent hydrogen atom, halogen atom, nitro group, cyano group, a monovalent organic group or a monovalent organic group to which at least one selected from the group consisting of halogen atom, nitro group and cyano group is introduced.

Formula (9):

Formula (A-2)

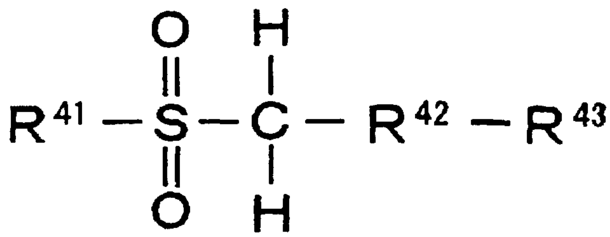

In the formula (A-2), $R^{41}$ and $R^{43}$ independently represent a monovalent organic group or a monovalent organic group to which at least one selected from the group consisting of halogen atom, nitro group and cyano group is introduced, $R^{42}$ represents a sulfonyl group or carbonyl group.

Formula (10):

Formula (A-3)

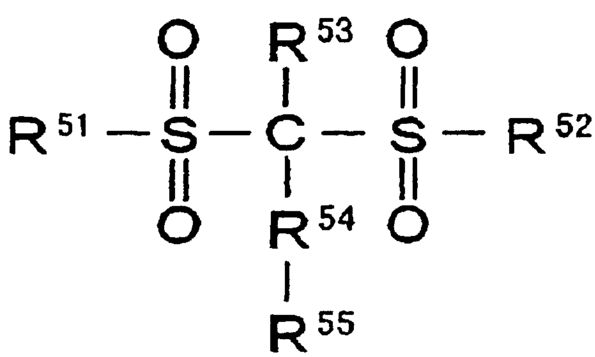

In the above formula (A-3), $R^{51}$, $R^{52}$ and $R^{55}$ independently represent a monovalent organic group or a monovalent organic group to which at least one selected from the group consisting of halogen atom, nitro group and cyano group is introduced, $R^{53}$ represents hydrogen atom, a monovalent organic group or a monovalent organic group to which at least one selected from the group consisting of halogen atom, nitro group and cyano group is introduced, $R^{54}$ represents a sulfonyl group, sulfinyl group, sulfur atom or carbonyl group.

Examples of the monovalent organic group which is introduced to the compound of the formula (A-1) as $R^{31}$, $R^{32}$, $R^{33}$ and $R^{34}$ are allyl, anisyl, anthraquinonyl, acetonaphthyl, anthryl, azulenyl, benzofuranyl, benzoquinonyl, benzoxadinyl, benzoxazoryl, benzyl, biphenylenyl, bornyl, butenyl, butyl, cinnamyl, cresotoyl, cumenyl, cyclobutanedienyl, cyclobutenyl, cyclobutyl, cyclopentadienyl, cyclopentatolyenyl, cycloheptyl, cyclohexenyl, cyclopentyl, cyclopropyl, cyclopropenyl, desyl, dimethoxyphenetyl, diphenylmethyl, docosyl, dodecyl, eicosyl, ethyl, fluorenyl, furfuryl, geranyl, heptyl, hexadecyl, hexyl, hydroxymethyl, indanyl, isobutyl, isopropyl, isopropylbenzyl, isoxazolyl, menthyl, mesityl, methoxybenzyl, methoxyphenyl, methyl, methylbenzyl, naphthyl, naphthylmethyl, nonyl, norbornyl, octacosyl, octyl, oxazinyl, oxazolidinyl, oxazolinyl, oxazolyl, pentyl, phenacyl, phenanthryl, phenetyl, phenyl, phthalidyl, propynyl, propyl, pyranyl, pyridyl, quinazolinyl, quinolyl, salicyl, terephthalyl, tetrazolyl, thiazolyl, thiaphtenyl, thienyl, tolyl, trityl, trimethylsilylmethyl, trimethylsilyloxymethyl, undecyl, valeryl, veratryl, xylyl and the like.

Examples of the monovalent organic group to which at least one selected from the group consisting of halogen atom, nitro group and cyano group is introduced are the above-mentioned groups in which hydrogen atom is replaced.

Examples of the compound of the above-mentioned formula (A-1) are phenyl methyl sulfone, ethyl phenyl sulfone, phenyl propyl sulfone, methyl benzyl sulfone, benzyl sulfone (dibenzyl sulfone), methyl sulfone, ethyl sulfone, butyl sulfone, methyl ethyl sulfone, methyl sulfonyl acetonitrile, phenylsulfonyl acetonitrile, toluenesulfonyl acetonitrile, benzyl phenyl sulfone, nitrophenyl sulfonyl acetonitrile, fluorophenyl sulfonyl acetonitrile, chlorophenyl sulfonyl acetonitrile, methoxyphenyl sulfonyl acetonitrile, α-methylphenyl sulfonyl acetonitrile, ethylsulfonyl acetonitrile, methylthiomethyl-p-toluyl sulfone, phenylsulfonyl acetophenone, phenylsulfonyl propionitrile, phenylsulfonyl propionate and ester compounds thereof, bromomethyl-2-(phenylsulfonylmethyl)benzene, naphthylmethylsulfone, 1-methyl-2-((phenylsulfonyl)methyl)benzene, trimethyl-3-(phenylsulfonyl)orthopropionate and the like.

In the present invention, among the compounds of the above-mentioned formula (A-1), preferred are those in which at least one of $R^{32}$, $R^{33}$ and $R^{34}$ is an electron attractive group. Particularly preferred is one having cyano group from the viewpoint of a high efficiency of acid generation at exposing and enhancement of sensitivity of a photosensitive composition (resist).

Also the compound in which at least one of $R^{32}$, $R^{33}$ and $R^{34}$ is hydrogen atom is preferred because solubility in alkali is high and generation of a scum is reduced when a developing treatment is carried out using an alkali solution for developing a resist.

In the compounds of the above-mentioned formula (A-1), a ring may be formed by bonding of $R^{31}$ to $R^{32}$, $R^{33}$ or $R^{34}$ or bonding of $R^{32}$, $R^{33}$ and $R^{34}$ to each other. In that case, examples of the formed cyclic compound are thiopyrandioxide compounds such as phenylsulfonyl tetrahydropyran, phenylsulfonyl cyclohexane, 3-phenyl-2H-thiopyran-1,1-dioxide and 6-methyl-3-phenyl-2H-thiopyran-1,1-dioxide, biscyclictrisulfone compounds such as trimethylene sulfone, tetramethylene sulfone and 4-methyl-2,6,7-trithiabicyclo[2,2,2]-octane-2,2,6,6,7,7-hexaoxide, and compounds represented by the following formula (11).

Formula (11):

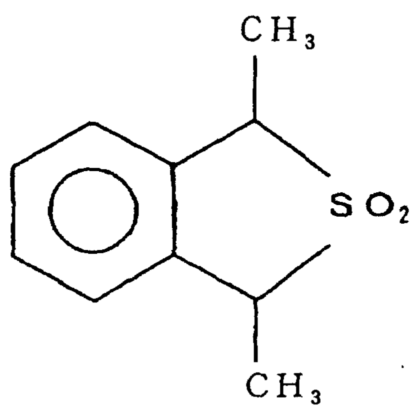

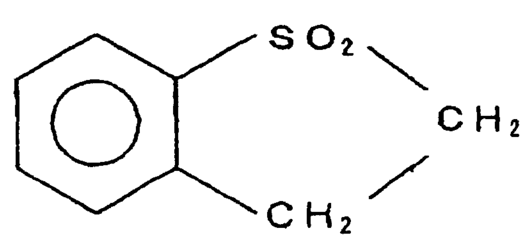

The compound of the above-mentioned formula (A-2) is an organic compound in which to a specific carbon atom are bonded two sulfonyl groups or one sulfonyl group and one carbonyl group. Examples of the monovalent organic groups which are introduced as $R^{41}$ and $R^{43}$ to the compound (A-2) are the same as the groups raised as the monovalent organic groups which are introduced to the above-mentioned compound (A-1). Also hydrogen atom of those organic groups may be substituted with at least one selected from the group consisting of halogen atom, nitro group and cyano group.

Examples of the above-mentioned compound (A-2) are bis(phenylsulfonyl)methane, bis(methylsulfonyl)methane, bis(ethylsulfonyl)methane, (methylsulfonyl)(phenylsulfonyl)methane, phenylsulfonyl acetophenone, methylsulfonyl acetophenone and the like.

In the compound (A-2), too, $R^{41}$ and $R^{43}$ may be bonded to each other to form a ring. In that case, examples of the formed cyclic compound are, for instance, cyclic sulfone compounds represented by the following formula (12).

Formula (12):

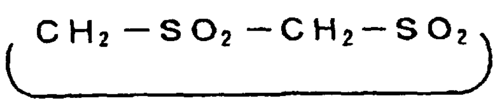

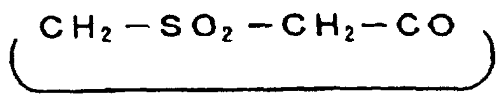

In the present invention, the above-mentioned compound (A-2) is a more preferred acid-generator because an alkali solubility and an efficiency of acid generation at exposing are high and sensitivity of a photosensitive composition (resist) is enhanced.

The above-mentioned compound (A-3) which is used as an acid-generator is an organic compound in which to a specific carbon atom are bonded at least two sulfonyl groups and further a linkage group having sulfur atom and one carbonyl group. Examples of the monovalent organic groups which are introduced as $R^{51}$, $R^{52}$, $R^{53}$ and $R^{55}$ to the compound (A-3) are the same as the groups raised as the monovalent organic groups which are introduced to the above-mentioned compound (A-1). Further hydrogen atom of those organic groups may be substituted with at least one selected from the group consisting of halogen atom, nitro group and cyano group, hydroxyl, carboxyl or esterified carboxyl. Examples of preferred $R^{54}$ are sulfonyl group, sulfinyl group and sulfur atom.

Examples of the above-mentioned compound (A-3) are tris(phenylsulfonyl)methane, phenylthio-bis(phenylsulfonyl)-methane, phenylmercapto-bis(methylsulfonyl)-methane, tris(methylsulfonyl)methane, tris(ethylsulfonyl) methane, bis(phenylsulfonyl)-methylsulfonyl-methane, bis(methylsulfonyl)-phenylsulfonyl-methane, phenylsulfonyl-ethylsulfonyl-methylsulfonyl-methane, tris(4-nitophenylsulfonyl)methane, tris(2,4-nitrophenylsulfonyl)methane, bis (phenylsulfonyl)-(4-nitrophenylsulfonyl)-methane, bis(phenylsulfonyl)-(3-nitrophenylsulfonyl)-methane, bis(phenylsulfonyl)-(2-nitrophenylsulfonyl)-methane, bis(phenylsulfonyl)-(p-tolylsulfonyl)-methane, bis(methylsulfonyl)-(4-nitrophenylsulfonyl)-methane, bis(methylsulfonyl)-(4-chlorophenylsulfonyl)-methane, bis(phenylsulfonyl)-(4-chlorophenylsulfonyl)-methane, 1,1,1-tris(phenylsulfonyl)ethane and the like.

In the above-mentioned compounds (A-1), (A-2) and (A-3), it is preferable that, for example, $R^{31}$, at least one of $R^{41}$ and $R^{43}$ or at least one of $R^{51}$, $R^{52}$ and $R^{55}$ is an aromatic group from the point that particularly when exposing is carried out using laser beam, dry etching resistance and heat resistance of the resist are enhanced. In addition, the acid-generators having a melting point of not less than 50°C and a high solubility in an organic solvent are also preferred.

On the other hand, when the compounds (A-1), (A-2) and (A-3) are the sulfonyl compounds having a basic substituent such as sulfone amide, there is a case where an acid generated by the exposing is inactivated. Also in the case of sulfonyl compounds having an acid group having a high solubility in alkali such as sulfonic acid, there is a case where solubility in alkali at an un-exposed portion of the photosensitive composition is increased excessively. Therefore with respect to the sulfonyl compounds, there is a case where use thereof as an acid-generator in the composition of the present invention is strictly limited.

An adding amount of the acid-generator is preferably from 0.05 to 30 parts by weight, more preferably from 0.1 to 10 parts by weight based on 100 parts by weight of the whole photosensitive composition.

The reason for this is such that if the amount of the acid-generator is too small, an acid enough for initiating a catalytic reaction is not generated and therefore the catalytic reaction by the generated acid is not advanced and sufficient photosensitivity is hardly imparted to the photosensitive composition. On the other hand, if the amount of the acid-generator is too large, a glass transition point and coatability of the photosensitive composition are lowered, which results in a fear that heat resistance and strength of the obtained resist pattern are lowered and a residue of the acid-generator is generated after the developing or after the etching.

Also if the adding amount thereof in the photosensitive composition is too large, particularly when the photosensitive composition is exposed to $F_2$ laser beam having a wavelength of 157 nm, since some of the above-mentioned acid-generators have a high absorption at a wavelength of exposure light, transmittance of beam through the photosensitive composition is significantly lowered and uniform exposing is difficult.

Those acid-generators may be used alone or in a mixture of two or more thereof.

In the chemically amplifying resist, there is known a method of controlling a scattering distance of an acid in the photosensitive composition and increasing resolution by adding a basic substance. In the photosensitive composition of the present invention, too, the same effect can be expected. In that case, an adding amount of the basic substance is preferably from 0.05 to 10 parts by weight, more preferably from 0.5 to 5 parts by weight based on 100

parts by weight of the acid-generator. If the amount is smaller than the above-mentioned amount, sufficient effect cannot be produced by adding the basic substance, and on the contrary, if the amount is larger than the above-mentioned amount, much of the generated acid is neutralized and inactivated, and therefore sensitivity of the photosensitive composition is significantly lowered.

To the photosensitive composition used for the method of forming a fine pattern of the present invention may be blended a known dissolution inhibitor as case demands. The dissolution inhibitor has an action of controlling alkali solubility of the fluorine-containing polymer from outside thereof.

In the present invention, there can be used known dissolution inhibitors such as an indene-carboxylic acid dissolution inhibitor, ether dissolution inhibitor, ester dissolution inhibitor, carbonate dissolution inhibitor and steroid dissolution inhibitor (Proceedings of SPIE, Vol. 920, pp. 42 (1988) and Vol. 920, pp. 60 (1988), Chemistry and Materials, Vol. 12, No. 11, pp. 3516 (2000), Journal of Photopolymer Science and Technology, Vol. 8, No.4, pp. 623 (1995)).

Preferred examples thereof are:

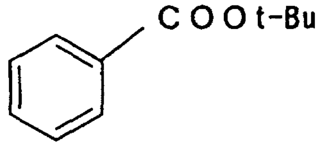

,

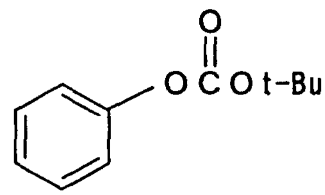

,

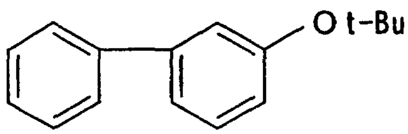

,

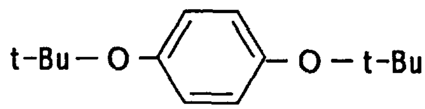

,

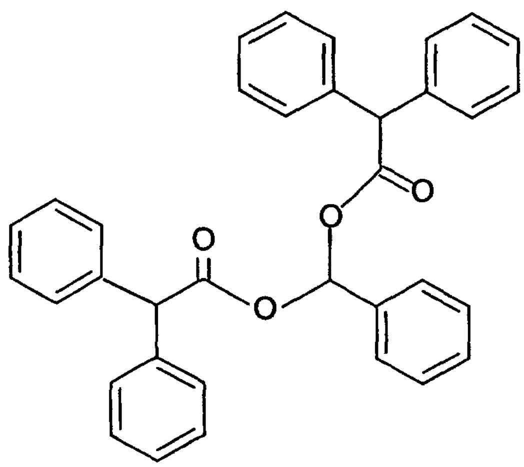

and in addition, t-butyl cholate glutarate dimer and the like.

Recently there have been proposed various dissolution inhibitors desirable for a resist for $F_2$ laser (Proceedings of SPIE, Vol. 4690, pp. 477 (2002) and Journal of Photopolymer Science and Technology, Vol. 14, No.4, pp. 669 (2001)), and those dissolution inhibitors can also be used in the present invention.

Preferred examples thereof are the following compounds.

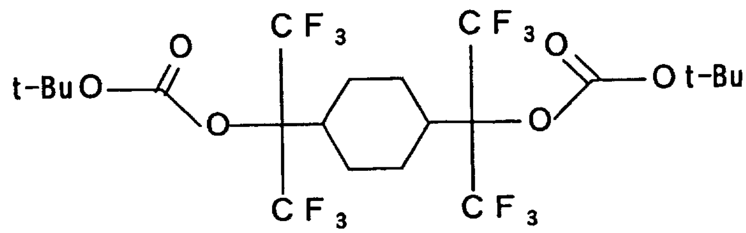

,

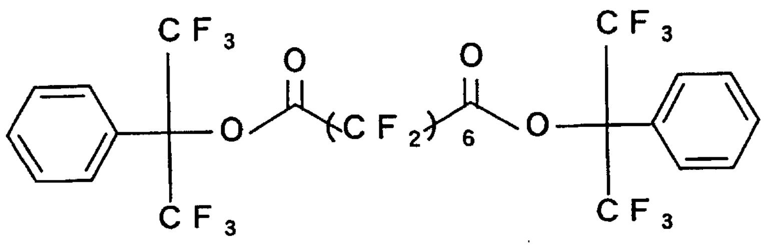

,

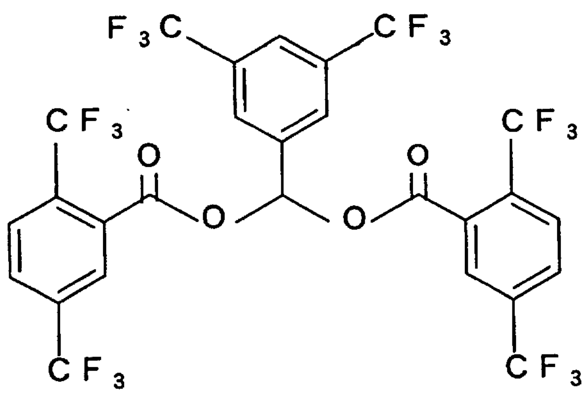

,

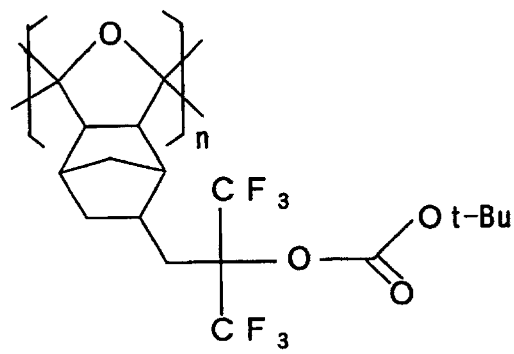

,

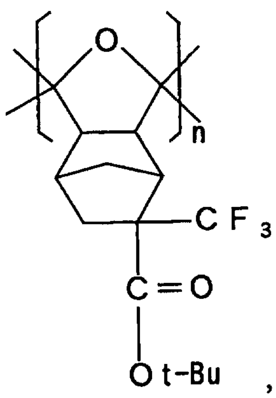

,

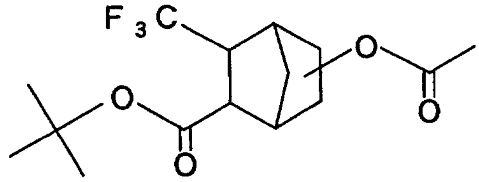

,

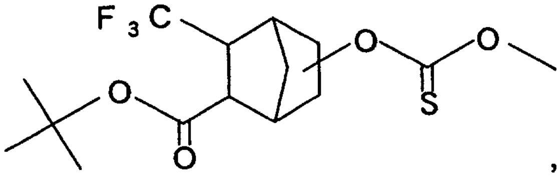
,
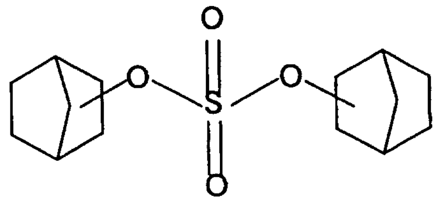

An adding amount of the dissolution inhibitor may be optionally selected depending on characteristics of a fluorine-containing polymer as a base polymer and characteristics of an obtained resist solution, and is generally from about 0.1 % by weight to about 20 % by weight, preferably from about 0.1 % by weight to about 5 % by weight based on the fluorine-containing polymer.

Then the solvent for the photosensitive composition used in the method of forming a fine pattern of the present invention is explained below.

The photosensitive resin (photosensitive composition) which is used in the present invention can be prepared by dissolving, in a given solvent, an alkali soluble resin and a compound (acid-generator) which generates an acid by irradiating with energy rays such as $F_2$ laser beam.

The solvent is not limited particularly as far as it can be usually used as a solvent for a photosensitive composition. Non-limiting examples thereof are, for instance, ketone solvents such as cyclohexanone, acetone, methyl ethyl ketone (2-butanone), methyl isobutyl ketone and 2-heptanone; cellosolve solvents such as methyl cellosolve, methyl cellosolve acetate, ethyl cellosolve and ethyl cellosolve acetate; ester solvents such as ethyl acetate, butyl acetate, isoamyl acetate, ethyl lactate and γ-butyrolactone; lactone solvents; glycol solvents such as propylene glycol monomethylether acetate (PGMEA); dimethyl sulfoxide; N-methylpyrrolidone; and the like.

Those solvents may be used alone or as a solvent mixture comprising two or more thereof.

The solvent mixture may contain a proper amount of, for example, aromatic hydrocarbon such as xylene or toluene, aliphatic alcohol such as ethanol or isopropyl alcohol (2-propanol) or a solvent derived therefrom.

Among the above-mentioned solvents, preferred is propylene glycol monomethylether acetate (PGMEA). Since a trace amount of the solvent remaining in the photosensitive composition affects characteristics of the photosensitive composition, PGMEA is suitable from the viewpoint of its boiling point, solubility parameter and polarity.

In addition to propylene glycol monomethylether acetate (PGMEA), ethyl lactate is also preferable as a solvent for the photosensitive composition.

Next, the method of forming a pattern of the present invention is explained by means of the drawing.

Mentioned below is the explanation in the case where the photosensitive composition obtained from a fluorine-containing resin is used as a positive type resist.

Fig. 1 is a cross-sectional view showing the method of forming a fine pattern of the present invention using the photosensitive composition obtained from a fluorine-containing resin.

First, as shown in Fig. 1(a), the photosensitive composition obtained from a fluorine-containing resin is coated on a substrate 11 by a rotary coating method or the like in a coating thickness of from 0.01 to 5 μm, preferably from 0.05 to 0.5 μm, more preferably from 0.1 to 0.3 μm.

Next, pre-baking treatment is carried out at a pre-determined temperature of not more than 150°C, preferably from 80° to 130°C to form a resin layer (layer of photosensitive composition), namely a resist layer 12.

Non-limiting examples of the above-mentioned substrate are, for instance, a silicon wafer, silicon wafer provided with various insulation films, electrode and wiring on a surface thereof and having steps, mask blank, semiconductor wafer of III-V group compound such as GaAs and AlGaAs, semiconductor wafer of II-VI group compound, piezoelectric wafer of crystal, quartz or lithium tantalate and the like.

Then as shown in Fig. 1(b), a pattern is drawn on the resist layer 12 by irradiating energy rays such as $F_2$ laser beam as shown by an arrow 15 through a mask 13 having a desired pattern and thus selectively exposing a specific area 14.

In that case, it is generally possible to use, as an exposure light, energy rays (or chemical radiation), namely, X-ray, high energy electron beam, synchrotron radiation, characteristic radiation of high pressure mercury lamp, laser beam other than $F_2$ laser beam or the like or to scan electron beam, ion beam or the like without using the mask to directly expose the resist film to the pattern. The effect of the present invention is exhibited most when $F_2$ laser beam is used as exposure light.

Subsequently by carrying out baking at a temperature of from 70° to 160°C, preferably from 90° to 140°C, for about 30 seconds to about 10 minutes after the exposing, a latent image 16 is formed on the exposed area 14 of the resist film as shown in Fig. 1(c). At that time, an acid generated by the exposing acts as a catalyst to decompose

the dissolution-inhibiting group (dissolution inhibitor) and thereby solubility in alkali is increased and the exposed area of the resist film becomes soluble in an aqueous alkali solution.

Then when the resist film 12 baked after the exposing is subjected to developing with an aqueous alkali solution, the un-exposed area of the resist film 12 remains on the substrate because its solubility in the aqueous alkali solution is low but the exposed area 14 is dissolved in the developing solution as mentioned above.

Next, after flowing away the developing solution with pure water, lower alcohol or a mixture thereof, the substrate is dried and thus a desired resist pattern 17 can be formed as shown in Fig. 1(d).

Mentioned above is the explanation in the case of the positive type chemically amplifying resist, but also when the photosensitive composition is used on the negative type resist, since an acid generated by the exposing participates in the reaction of the alkali soluble resin with a crosslinking agent and also the reaction of making the resin insoluble in alkali by changing a structure of a substituent, there can be obtained such an effect that a pattern can be formed in high sensitivity like the above-mentioned case of positive type resist.

While the above-mentioned explanation is made with respect to the case of using $F_2$ laser beam as the energy ray, ArF laser beam is also suitable as the energy ray used for the method of forming a fine pattern of the present invention.

Also KrF laser beam is suitable as the energy ray used for the method of forming a fine pattern of the present invention.

High energy electron beam is also suitable as the energy ray used for the method of forming a fine pattern of the present invention.

Also high energy ion beam is suitable as the energy ray used for the method of forming a fine pattern of the present invention.

Also X-ray generated from synchrotron radiation is suitable as the energy ray used for the method of forming a fine pattern of the present invention.

Though the above-mentioned explanation is made with respect to the case of forming the resist film on the substrate 11, the formation of the resist film is not limited to the case of forming the resist film on a so-called substrate. The resist film may also be formed on a specific layer such as an electrically conductive film, insulating film or the like which is formed on the substrate. Also it is possible to form an antireflection film, for example, DUV-30, DUV-32, DUV-42 and DUV44 available from Brewer Science Co., Ltd. on the substrate. The resist film may be formed on a substrate treated with an adhesion improver, thus making it possible to enhance adhesion of the photosensitive composition to the substrate. The substrate is also not limited to those for production of semiconductor devices and includes various substrates for production of electronic devices as mentioned above.

Also when an intended fine pattern of an electrically conductive film or an insulating film is formed by using the so-formed fine resist pattern as a mask and etching a specific layer under the mask and then other steps are carried out, semiconductor devices and electronic devices can be produced. Since those steps are well known, explanation thereof is omitted.

The present invention is then explained by means of examples and preparation examples, but is not limited to those examples.

PREPARATION EXAMPLE 1

(Synthesis of copolymer comprising norbornene and tetrafluoroethylene)

A 300 ml autoclave was charged with 10.8 g of bicyclo(2.2.1)hepto-2-ene(2-norbornene), 140 ml of HCFC-141b and 0.5 g of bis(4-tert-butylcyclohexyl)peroxydicarbonate (TCP), and while cooling with dry ice/methanol solution, the inside of a system was sufficiently replaced with nitrogen gas. Then 36.0 g of tetrafluoroethylene (TFE) was introduced through a valve, followed by shaking for reaction at 40°C for 12 hours. With the advance of the reaction, a gauge pressure was decreased from 0.96 MPaG (9.8 kgf/$cm^2$G) before the reaction to 0.87 MPaG (8.9 kgf/$cm^2$G).

After releasing the un-reacted monomer, the polymerization solution was removed, followed by concentration and re-precipitation with hexane to separate a copolymer. Until a constant weight was reached, vacuum drying was continued and 7.5 g of a copolymer was obtained.

As a result of $^1$H-NMR and $^{19}$F-NMR analyses, the copolymer was one comprising TFE/2-norbornene in a percent by mole ratio of 50/50. According to GPC analysis, a number average molecular weight of the copolymer was 12,000.

PREPARATION EXAMPLE 2

(Synthesis of copolymer comprising tetrafluoroethylene and fluorine-containing norbornene having $-COOC(CH_3)_3$ group)

A 300 ml autoclave was charged with 15.9 g of a fluorine-containing norbornene derivative having $-COOC(CH_3)_3$ group represented by the following formula:

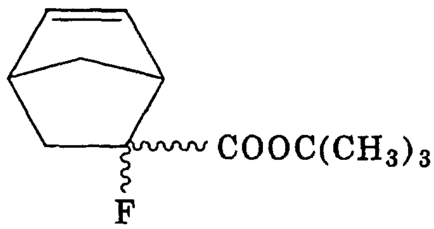

,

140 ml of HCFC-141b and 1.0 g of bis(4-tert-butylcyclohexyl)peroxydicarbonate (TCP), and while cooling with dry ice/methanol solution, the inside of a system was sufficiently replaced with nitrogen gas. Then 30.0 g of tetrafluoroethylene (TFE) was introduced through a valve, followed by shaking for reaction at 40°C for 12 hours. With the advance of the reaction, a gauge pressure was decreased from 1.00 MPaG (10.2 kgf/$cm^2$G) before the reaction to 0.94 MPaG (9.6 kgf/$cm^2$G).

After releasing the un-reacted monomer, the polymerization solution was removed, followed by re-precipitation with methanol to separate a copolymer. Until a constant weight was reached, vacuum drying was continued and 8.5 g of a copolymer was obtained.

As a result of $^{19}$F-NMR analysis, the copolymer was a copolymer comprising TFE/fluorine-containing norbornene derivative having $-COOC(CH_3)_3$ group in a percent by mole ratio of 50/50. According to GPC analysis, a number average molecular weight thereof was 4,800.

PREPARATION EXAMPLE 3

(Synthesis of copolymer comprising norbornene, tetrafluoroethylene and tert-butyl-αfluoroacrylate)

A 300 ml autoclave was charged with 10.8 g of 2-norbornene, 8.0 g of tert-butyl-αfluoroacrylate, 140 ml of HCFC-141b and 0.5 g of bis(4-tert-butylcyclohexyl)peroxydicarbonate (TCP), and while cooling with dry ice/methanol solution, the inside of a system was sufficiently replaced with nitrogen gas. Then 36.0 g of tetrafluoroethylene (TFE) was introduced through a valve, followed by shaking for reaction at 40°C for 12 hours. With the advance of the reaction, a gauge pressure was decreased from 1.00 MPaG (10.2 kgf/$cm^2$G) before the reaction to 0.89 MPaG (9.1 kgf/$cm^2$G).

After releasing the un-reacted monomer, the polymerization solution was removed, followed by re-precipitation with methanol to separate a copolymer. Until a constant weight was reached, vacuum drying was continued and 15.0 g of a copolymer was obtained.

As a result of $^1$H-NMR and $^{19}$F-NMR analyses, the copolymer was one comprising TFE/2-norbornene/tert-butyl-αfluoroacrylate in a percent by mole ratio of 43/33/24. According to GPC analysis, a number average molecular weight of the copolymer was 14,000.

PREPARATION EXAMPLE 4

(Synthesis of copolymer comprising norbornene, tetrafluoroethylene and tert-butyl-αfluoroacrylate)

Reaction was carried out in the same manner as in Preparation Example 3 except that 10.8 g of 2-norbornene and 5.5 g of tert-butyl-αfluoroacrylate were used. With the advance of the reaction, a gauge pressure was decreased from 1.00 MPaG (10.2 kgf/$cm^2$G) before the reaction to 0.93 MPaG (9.5 kgf/$cm^2$G). After releasing the un-reacted monomer, a polymer was isolated in the same manner as in Preparation Example 3 and 12.1 g of a copolymer was obtained.

As a result of $^1$H-NMR and $^{19}$F-NMR analyses, the copolymer was one comprising TFE/2-norbornene/tert-butyl-αfluoroacrylate in a percent by mole ratio of 32/57/11. According to GPC analysis, a number average molecular weight of the copolymer was 9,900.

PREPARATION EXAMPLE 5

(Synthesis of copolymer comprising norbornene, tetrafluoroethylene and tert-butyl-αfluoroacrylate)

Reaction was carried out in the same manner as in Preparation Example 3 except that 10.8 g of 2-norbornene and 9.5 g of tert-butyl-αfluoroacrylate were used. With the advance of the reaction, a gauge pressure was decreased from 1.06 MPaG (10.8 kgf/$cm^2$G) before the reaction to 0.88 MPaG (9.0 kgf/$cm^2$G). After releasing the un-reacted monomer, a polymer was isolated in the same manner as in Preparation Example 3 and 19.5 g of a copolymer was obtained.

As a result of $^1$H-NMR and $^{19}$F-NMR analyses, the copolymer was one comprising TFE/2-norbornene/tert-butyl-αfluoroacrylate in a percent by mole ratio of 31/30/39. According to GPC analysis, a number average molecular weight of the copolymer was 15,000.

PREPARATION EXAMPLE 6

(Synthesis of copolymer comprising norbornene, tetrafluoroethylene and tert-butyl-αfluoroacrylate)

Reaction was carried out in the same manner as in Preparation Example 3 except that 10.8 g of 2-norbornene and 10.1 g of tert-butyl-αfluoroacrylate were used. With the advance of the reaction, a gauge pressure was decreased from 1.06 MPaG (10.8 kgf/$cm^2$G) before the reaction to 0.90 MPaG (9.2 kgf/$cm^2$G). After releasing the un-reacted monomer, a polymer was isolated in the same manner as in Preparation Example 3 and 20.2 g of a copolymer was obtained.

As a result of $^1$H-NMR and $^{19}$F-NMR analyses, the copolymer was one comprising TFE/2-norbornene/tert-butyl-αfluoroacrylate in a percent by mole ratio of 28/28/44. According to GPC analysis, a number average molecular weight of the copolymer was 15,000.

PREPARATION EXAMPLE 7

(Synthesis of copolymer comprising norbornene, tetrafluoroethylene and tert-butyl-αfluoroacrylate)

Reaction was carried out in the same manner as in Preparation Example 3 except that 10.8 g of 2-norbornene and 15.6 g of tert-butyl-αfluoroacrylate were used. With the advance of the reaction, a gauge pressure was decreased from 1.06 MPaG (10.8 kgf/$cm^2$G) before the reaction to 0.81 MPaG (8.3 kgf/$cm^2$G). After releasing the un-reacted monomer, a polymer was isolated in the same manner as in Preparation Example 3 and 24.2 g of a copolymer was obtained.

As a result of $^1$H-NMR and $^{19}$F-NMR analyses, the copolymer was one comprising TFE/2-norbornene/tert-butyl-αfluoroacrylate in a percent by mole ratio of 13/22/65. According to GPC analysis, a number average molecular weight of the copolymer was 17,000.

PREPARATION EXAMPLE 8

(Synthesis of copolymer comprising norbornene, tetrafluoroethylene and tert-butyl-αfluoroacrylate)

Reaction was carried out in the same manner as in Preparation Example 3 except that 10.8 g of 2-norbornene and 16.9 g of tert-butyl-αfluoroacrylate were used. With the advance of the reaction, a gauge pressure was decreased from 0.96 MPaG (9.8 kgf/$cm^2$G) before the reaction to 0.74 MPaG (7.5 kgf/$cm^2$G). After releasing the un-reacted monomer, a polymer was isolated in the same manner as in Preparation Example 3 and 31.0 g of a copolymer was obtained.

As a result of $^1$H-NMR and $^{19}$F-NMR analyses, the copolymer was one comprising TFE/2-norbornene/tert-butyl-αfluoroacrylate in a percent by mole ratio of 11/19/70. According to GPC analysis, a number average molecular weight of the copolymer was 23,000.

PREPARATION EXAMPLE 9

(Synthesis of copolymer comprising cyclopentene and tetrafluoroethylene)

A 100 ml autoclave was charged with 3.4 g of cyclopentene, 40 ml of HCFC-141b and 0.3 g of bis(4-tert-butylcyclohexyl)peroxydicarbonate (TCP), and while cooling with dry ice/methanol solution, the inside of a system was

sufficiently replaced with nitrogen gas. Then 10.0 g of tetrafluoroethylene (TFE) was introduced through a valve, followed by shaking for reaction at 40°C for 18 hours. With the advance of the reaction, a gauge pressure was decreased from 0.78 MPaG (8.0 kgf/$cm^2$G) before the reaction to 0.75 MPaG (7.7 kgf/$cm^2$G).

After releasing the un-reacted monomer, the polymerization solution was removed, followed by re-precipitation with hexane to separate a copolymer. Until a constant weight was reached, vacuum drying was continued and 1.5 g of a copolymer was obtained.

As a result of $^1$H-NMR and $^{19}$F-NMR analyses, the copolymer was one comprising TFE/cyclopentene in a percent by mole ratio of 50/50. According to GPC analysis, a number average molecular weight of the copolymer was 5,700.

PREPARATION EXAMPLE 10

(Synthesis of copolymer comprising 2,3dihydrofuran and tetrafluoroethylene)

Reaction was carried out in the same manner as in Preparation Example 9 except that 3.5 g of 2,3dihydrofuran was used instead of cyclopentene. With the advance of the reaction, a gauge pressure was decreased from 0.78 MPaG (8.0 kgf/$cm^2$G) before the reaction to 0.75 MPaG (7.7 kgf/$cm^2$G). After releasing the un-reacted monomer, a polymer was isolated in the same manner as in Preparation Example 9 and 2.1 g of a copolymer was obtained.

As a result of $^1$H-NMR and $^{19}$F-NMR analyses, the copolymer was one comprising TFE/2,3dihydrofuran in a percent by mole ratio of 50/50. According to GPC analysis, a number average molecular weight of the copolymer was 17,000.

PREPARATION EXAMPLE 11

(Synthesis of copolymer comprising 2-cyclopentene-1-tert-butylacetate and tetrafluoroethylene)

A 100 ml autoclave was charged with 4.6 g of 2-cyclopentene-1-tert-butylacetate represented by the following formula:

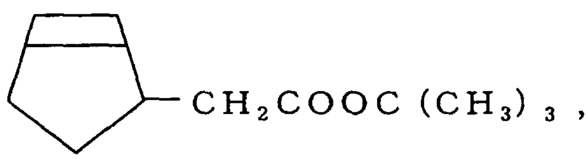

40 ml of HCFC-141b and 0.5 g of bis(4-tert-butylcyclohexyl)peroxydicarbonate (TCP), and while cooling with dry ice/methanol solution, the inside of a system was sufficiently replaced with nitrogen gas. Then 10.0 g of tetrafluoroethylene (TFE) was introduced through a valve, followed by shaking for reaction at 40°C for 18 hours. With the advance of the reaction, a gauge pressure was decreased from 0.98 MPaG (10.0 kgf/$cm^2$G) before the reaction to 0.96 MPaG (9.8 kgf/$cm^2$G).

After releasing the un-reacted monomer, the polymerization solution was removed, followed by re-precipitation with hexane to separate a copolymer. Until a constant weight was reached, vacuum drying was continued and 1.0 g of a copolymer was obtained.

As a result of elementary analysis, the copolymer was one comprising TFE/2-cyclopentene-1-tert-butylacetate in a percent by mole ratio of 50/50. According to GPC analysis, a number average molecular weight of the copolymer was 1,800.

PREPARATION EXAMPLE 12

(Synthesis of copolymer comprising 2,3-dihydrofuran, tetrafluoroethylene and tert-butyl-αfluoroacrylate)

A 500 ml autoclave was charged with 7.0 g of 2,3-dihydrofuran, 5.8 g of tert-butyl-αfluoroacrylate, 240 ml of HCFC-225 and 0.8 g of bis(4-tert-butylcyclohexyl)peroxydicarbonate (TCP), and while cooling with dry ice/methanol solution, the inside of a system was sufficiently replaced with nitrogen gas. Then 40.0 g of tetrafluoroethylene (TFE) was introduced through a valve, followed by shaking for reaction at 40°C for 18 hours. With the advance of the reaction, a gauge pressure was decreased from 0.88 MPaG (9.0 kgf/$cm^2$G) before the reaction to 0.86 MPaG (8.8 kgf/$cm^2$G).

After releasing the un-reacted monomer, the polymerization solution was removed, followed by re-precipitation

with hexane to separate a copolymer. Until a constant weight was reached, vacuum drying was continued and 11.2 g of a copolymer was obtained.

As a result of $^1$H-NMR and $^{19}$F-NMR analyses, the copolymer was one comprising TFE/2,3-dihydrofuran/tert-butyl-αfluoroacrylate in a percent by mole ratio of 23/33/44. According to GPC analysis, a number average molecular weight of the copolymer was 18,000.

PREPARATION EXAMPLE 13

(Synthesis of copolymer comprising cyclopentene, tetrafluoroethylene and tert-butyl-αfluoroacrylate)

A 100 ml autoclave was charged with 3.4 g of cyclopentene, 1.5 g of tert-butyl-αfluoroacrylate, 40 ml of HCFC-225 and 0.3 g of bis(4-tert-butylcyclohexyl)peroxydicarbonate (TCP), and while cooling with dry ice/methanol solution, the inside of a system was sufficiently replaced with nitrogen gas. Then 10.0 g of tetrafluoroethylene (TFE) was introduced through a valve, followed by shaking for reaction at 40°C for 18 hours. With the advance of the reaction, a gauge pressure was decreased from 0.78 MPaG (8.0 kgf/cm$^2$G) before the reaction to 0.77 MPaG (7.9 kgf/cm$^2$G).

After releasing the un-reacted monomer, the polymerization solution was removed, followed by re-precipitation with hexane to separate a copolymer. Until a constant weight was reached, vacuum drying was continued and 2.2 g of a copolymer was obtained.

As a result of $^1$H-NMR and $^{19}$F-NMR analyses, the copolymer was one comprising TFE/cyclopentene/tert-butyl-αfluoroacrylate in a percent by mole ratio of 15.1/39.3/45.6. According to GPC analysis, a number average molecular weight of the copolymer was 12,000.

PREPARATION EXAMPLE 14

(Synthesis of copolymer comprising cyclopentene, tetrafluoroethylene and tert-butyl-αfluoroacrylate)

Reaction was carried out in the same manner as in Preparation Example 13 except that 1.7 g of cyclopentene and 1.5 g of tert-butyl-αfluoroacrylate were used. With the advance of the reaction, a gauge pressure was decreased from 0.78 MPaG (8.0 kgf/cm$^2$G) before the reaction to 0.74 MPaG (7.6 kgf/cm$^2$G).

After releasing the un-reacted monomer, a polymer was isolated in the same manner as in Preparation Example 13 and 1.7 g of a copolymer was obtained.

As a result of $^1$H-NMR and $^{19}$F-NMR analyses, the copolymer was one comprising TFE/cyclopentene/tert-butyl-αfluoroacrylate in a percent by mole ratio of 26.7/34.1/39.2. According to GPC analysis, a number average molecular weight of the copolymer was 14,000.

PREPARATION EXAMPLE 15

(Synthesis of copolymer comprising cyclopentene, tetrafluoroethylene and tert-butyl-αfluoroacrylate)

Reaction was carried out in the same manner as in Preparation Example 13 except that 3.4 g of cyclopentene and 4.5 g of tert-butyl-αfluoroacrylate were used. With the advance of the reaction, a gauge pressure was decreased from 0.78 MPaG (8.0 kgf/cm$^2$G) before the reaction to 0.75 MPaG (7.7 kgf/cm$^2$G). After releasing the un-reacted monomer, a polymer was isolated in the same manner as in Preparation Example 13 and 3.5 g of a copolymer was obtained.

As a result of $^1$H-NMR and $^{19}$F-NMR analyses, the copolymer was one comprising TFE/cyclopentene/tert-butyl-αfluoroacrylate in a percent by mole ratio of 6.6/51.9/41.5. According to GPC analysis, a number average molecular weight of the copolymer was 21,000.

EXPERIMENTAL EXAMPLE 1

(Evaluation of transparency at 157 nm)

A vacuum ultraviolet absorption spectrum of the fluorine-containing polymers obtained in Preparation Examples 1 to 15 was measured. An absorption coefficient per 1 μm at 157 nm of the fluorine-containing polymers obtained in each Preparation Example is shown in Table 1.

TABLE 1

| | Fluorine-containing polymer | Absorption coefficient ($\mu m^{-1}$) |
|---|---|---|
| Experimental Example 1 | Prep. Ex. 1 | 1.3 |
| | Prep. Ex. 2 | 3.2 |
| | Prep. Ex. 3 | 2.3 |
| | Prep. Ex. 4 | 3.7 |
| | Prep. Ex. 5 | 3.0 |
| | Prep. Ex. 6 | 3.1 |
| | Prep. Ex. 7 | 3.6 |
| | Prep. Ex. 8 | 4.1 |
| | Prep. Ex. 9 | 0.8 |
| | Prep. Ex. 10 | 1.1 |
| | Prep. Ex. 11 | 3.0 |
| | Prep. Ex. 12 | 3.3 |
| | Prep. Ex. 13 | 3.7 |
| | Prep. Ex. 14 | 3.5 |
| | Prep. Ex. 15 | 3.9 |

EXPERIMENTAL EXAMPLE 2

(Evaluation of dry etching resistance)

Propylene glycol monomethylether acetate (PGMEA) solutions of 10 % by weight of fluorine-containing copolymers obtained in Preparation Examples 1 to 15, respectively were prepared and coated on a silicon wafer with a spin coater so that the coating thickness became about 200 nm. The coating film was pre-baked at 110°C for one minute to obtain a coated silicon wafer. A coating thickness of the fluorine-containing copolymer film on the wafer was measured with an optical film thickness meter (Lambda Ace available from Dai-Nippon Screen Insatsu Kabushiki Kaisha).

Then the coated silicon wafer was subjected to etching at an etching time of 60 seconds under the following etching conditions.

(Etching conditions)

Equipment: Model IEM etching machine (available from Tokyo Electron Kabushiki Kaisha)
Pressure: 30 mTorr
Flow rate: Ar (400 sccm)/$C_4F_8$ (11 sccm)/$O_2$ (8 sccm)
Plasma conditions: 2,000 W, 27 MHz (upper electrode)
1,200 W, 800 kHz (lower electrode)
Gap: 20 mm
Temperature: Upper temperature of 30°C, Wall temperature of 40°C,
Electrode temperature of -20°C
Back pressure: 10 Torr (center)/35 Torr (edge)

A coating thickness of the fluorine-containing copolymer film on the wafer after the etching was measured with an optical film thickness meter (Lambda Ace available from Dai-Nippon Screen Insatsu Kabushiki Kaisha), and an etching rate was calculated from the film thickness before the etching. The results are shown in Table 2.

An etching rate of ArF resist (AX-431 available from Sumitomo Chemical Industries, Ltd.) was measured for comparison under the same etching conditions as above. The etching rate (RIE rate) of the fluorine-containing copolymers of Preparation Examples 1 to 15 was calculated provided that the etching rate of ArF resist was 1. The results are shown in Table 2.

TABLE 2

| | Fluorine-containing polymer | Etching rate (nm/min) | RIE rate |
|---|---|---|---|
| Experimental Example 2 | Prep. Ex. 1 | 76.1 | 0.8 |
| | Prep. Ex. 2 | 75.9 | 0.8 |
| | Prep. Ex. 3 | 85.4 | 0.9 |
| | Prep. Ex. 4 | 85.7 | 0.9 |
| | Prep. Ex. 5 | 94.9 | 1.0 |
| | Prep. Ex. 6 | 95.2 | 1.0 |
| | Prep. Ex. 7 | 113.7 | 1.2 |
| | Prep. Ex. 8 | 124 | 1.3 |
| | Prep. Ex. 9 | 76.1 | 0.8 |
| | Prep. Ex. 10 | 85.3 | 0.9 |
| | Prep. Ex. 11 | 88.4 | 0.93 |
| | Prep. Ex. 12 | 95.1 | 1.0 |
| | Prep. Ex. 13 | 106.4 | 1.12 |
| | Prep. Ex. 14 | 114.2 | 1.2 |
| | Prep. Ex. 15 | 152 | 1.6 |
| | ArF resist | 95.0 | 1 |

EXPERIMENTAL EXAMPLE 3

(Determination of relational equation between polymer structure and dry etching resistance)

(1) Calculation of $N_T$, $N_C$, $N_O$ and $N_F$

$N_T$, $N_C$, $N_O$ and $N_F$ of the fluorine-containing polymers of Preparation Examples 1 to 15 are calculated from proportions of each component of the respective polymers using the following equations.
$N_T$ = (Number of whole atoms in the structural unit M1) × (Molar fraction of M1) + (Number of whole atoms in the structural unit M2) × (Molar fraction of M2) + (Number of whole atoms in the structural unit A1) × (Molar fraction of A1).
$N_C$ = (Number of carbon atoms in the structural unit M1) × (Molar fraction of M1) + (Number of carbon atoms in the structural unit M2) × (Molar fraction of M2) + (Number of carbon atoms in the structural unit A1) × (Molar fraction of A1)
$N_O$ = (Number of oxygen atoms in the structural unit M1) × (Molar fraction of M1) + (Number of oxygen atoms in the structural unit M2) × (Molar fraction of M2) + (Number of oxygen atoms in the structural unit A1) × (Molar fraction of A1)
With respect to $N_F$, attention is directed only to the fluorine atoms bonded to the carbon atoms of the polymer trunk chain and bonded to the carbon atoms forming a ring structure, and $N_F$ is calculated in the same manner as above by:
$N_F$ = (Number of the above fluorine atoms in the structural unit M1) × (Molar fraction of M1) + (Number of the above fluorine atoms in the structural unit M2) × (Molar fraction of M2) + (Number of the above fluorine atoms in the structural unit A1) × (Molar fraction of A1).

(2) Calculation of parameter (X-1)

A parameter value of each polymer is calculated by substituting $N_T$, $N_C$, $N_O$ and $N_F$ of each polymer in the following equation.

$$N_T/(N_C - N_O + 4N_F^2)$$

The values calculated in (1) and (2) above and RIE rate obtained in Experimental Example 2 are shown in Table 3.

TABLE 3

| Polymer | $N_T$ | $N_C$ | $N_O$ | $N_F$ | $\frac{N_T}{N_C - N_O + 4N_F^2}$ | RIE rate |
|---|---|---|---|---|---|---|
| Prep. Ex. 1 | 11.5 | 4.5 | 0 | 2 | 0.56 | 0.8 |
| Prep. Ex. 2 | 19 | 7 | 1 | 2.5 | 0.61 | 0.8 |
| Prep. Ex. 3 | 13.23 | 4.85 | 0.48 | 1.96 | 0.67 | 0.9 |
| Prep. Ex. 4 | 13.92 | 5.5 | 0.22 | 1.39 | 1.07 | 0.9 |
| Prep. Ex. 5 | 15.15 | 5.45 | 0.78 | 1.63 | 0.99 | 1.0 |
| Prep. Ex. 6 | 15.18 | 5.6 | 0.88 | 1.56 | 1.08 | 1.0 |
| Prep. Ex. 7 | 18.17 | 6.35 | 1.3 | 1.17 | 1.73 | 1.2 |
| Prep. Ex. 8 | 18.59 | 6.45 | 1.4 | 1.14 | 1.81 | 1.3 |
| Prep. Ex. 9 | 9.5 | 4.85 | 0.84 | 2 | 0.47 | 0.8 |
| Prep. Ex. 10 | 8.5 | 3 | 0.5 | 2 | 0.46 | 0.9 |
| Prep. Ex. 11 | 18 | 6.5 | 1 | 2 | 0.83 | 0.93 |
| Prep. Ex. 12 | 14.25 | 4.86 | 1.21 | 1.36 | 1.29 | 1.0 |
| Prep. Ex. 13 | 15.59 | 5.46 | 0.91 | 1.06 | 1.72 | 1.12 |
| Prep. Ex. 14 | 14.27 | 4.98 | 0.78 | 1.46 | 1.12 | 1.2 |
| Prep. Ex. 15 | 15.86 | 5.63 | 0.83 | 0.68 | 2.11 | 1.6 |

(3) Determination of relational equation with dry etching resistance

With respect to each polymer, the values of $N_T/(N_C - N_O + 4N_F^2)$ calculated in (2) above are plotted on an abscissa (x axis) and the respective dry etching resistance (RIE rates) are plotted on an ordinate (y axis). The results are shown in Fig. 2.

From the graph of Fig. 2, it is seen that a good proportional relation is obtained. Also a relational equation:

$$(\text{RIE rate}) = 0.358 \frac{N_T}{N_C - N_O + 4N_F^{2}} + 0.629$$

is obtained from the graph.

EXPERIMENTAL EXAMPLE 4

Triphenylsulfonium triflate was added as a photoacid generator in an amount of 5 parts by weight to 100 parts by weight of the fluorine-containing copolymer prepared in Preparation Example 12, followed by dissolving in PGMEA. The obtained solution of photosensitive composition was applied on a silicon wafer with a spin coater and was dried at 110°C for 90 seconds to form a 0.11 μm thick resist film.

This resist film was subjected to frame exposure on a spot of 1 cm × 1 cm square (1 $cm^2$) by using $F_2$ laser beam (wavelength 157 nm). After the exposing, heating was carried out on a heated plate at 110°C for 90 seconds, followed by developing with an aqueous solution of tetramethylammonium hydroxide (TMAH) having a concentration of 2.38 % by weight.

When the above-mentioned frame exposure, heating and developing were carried out in the same manner as above by changing exposure energy of $F_2$ laser beam from 0.1 mJ/$cm^2$ to 100 mJ/$cm^2$, the spot of 1 $cm^2$ was completely dissolved at the exposure of not less than 2.1 mJ/$cm^2$, from which it was known that the fluorine-containing copolymer prepared in Preparation Example 12 had sensitivity which could make the copolymer function as a positive type resist.

The above-mentioned procedures were repeated by using a reduction projection exposure system using $F_2$ laser as light source. As a result, a 180 nm fine pattern could be produced at an exposure energy of 21.5 mJ/$cm^2$. From this, it was known that the fluorine-containing resin prepared in Preparation Example 12 had resolution which could make the resin function as a positive type resist.

EXPERIMENTAL EXAMPLE 5

A photosensitive composition was prepared and a resist film was formed in the same manner as in Experimental Example 4 except that the fluorine-containing copolymer obtained in Preparation Example 14 was used instead of the fluorine-containing copolymer obtained in Preparation Example 12. Then frame exposure using $F_2$ laser beam, heating and developing were carried out in the same manner as above.

As a result, the spot of 1 $cm^2$ was completely dissolved at an exposure energy of not less than 2.5 mJ/$cm^2$, from which it was known that the fluorine-containing copolymer prepared in Preparation Example 14 had sensitivity which could make the copolymer function as a positive type resist.

The above-mentioned procedures were repeated by using a reduction projection exposure system using $F_2$ laser as light source. As a result, a 180 nm fine pattern could be produced at an exposure energy of 25 mJ/$cm^2$. From this, it was known that the fluorine-containing resin prepared in Preparation Example 14 had resolution which could make the copolymer function as a positive type resist.

INDUSTRIAL APPLICABILITY

According to the present invention, a fine pattern having high resolution against exposure light having a short wavelength such as $F_2$ laser beam can be formed by using, as a resist, a highly practical photosensitive composition prepared from a specific fluorine-containing polymer having a high transparency against light having a short wavelength.

**Claims**

1. A method of forming a fine resist pattern comprising a step for forming a photosensitive layer on a substrate or on a given layer on the substrate by using a photosensitive composition comprising at least a compound generating an acid by irradiation of light and a fluorine-containing polymer, a step for exposing by selectively irradiating a given area of said photosensitive layer with energy ray, a step for heat-treating said exposed photosensitive layer, and a step for forming a fine pattern by developing said heat-treated photosensitive layer to selectively remove the exposed portion or un-exposed portion of said photo-sensitive layer;
   in which said fluorine-containing polymer is represented by the formula (1):

$$-(M1)-(M2)-(A1)- \quad (1)$$

wherein the structural unit M1 is a structural unit derived from a fluorine-containing monomer, in which at least one fluorine atom is bonded to any of carbon atoms forming the polymer trunk chain,
the structural unit M2 is a structural unit having an aliphatic ring structure in the polymer trunk chain,
the structural unit A1 is a structural unit derived from a monomer copolymerizable with the monomers to introduce the structural units M1 and M2,
provided that at least any one of the structural units M1, M2 and A1 has an acid-reactive functional group Y, and contents of the structural units M1, M2 and A1 are from 1 to 99 % by mole, from 1 to 99 % by mole and from 0 to 98 % by mole, respectively, and
said polymer satisfies Equation (X):

$$N_T/(N_C - N_O + 4N_F{}^2) \leq 2.0 \quad (X)$$

wherein $N_T$ is a compositional average number of whole atoms constituting the fluorine-containing polymer, $N_C$ is a compositional average number of carbon atoms, $N_O$ is a compositional average number of oxygen atoms and $N_F$ is a compositional average number of fluorine atoms bonded to carbon atoms of the polymer trunk chain and bonded to carbon atoms forming an aliphatic ring structure among fluorine atoms which constitute the fluorine-containing polymer.

**2.** The method of forming a fine resist pattern of Claim 1, wherein said fluorine-containing polymer is represented by the formula (2):

$$-(M1)-(M2\text{-}1)-(A1)- \quad (2)$$

wherein the structural unit M2-1 is a structural unit having an aliphatic monocyclic structure in the polymer trunk chain,
the structural unit M1 and A1 are as defined in the formula (1),
provided that at least any one of the structural units M1, M2-1 and A1 has an acid-reactive functional group Y, and contents of the structural units M1, M2-1 and A1 are from 1 to 99 % by mole, from 1 to 99 % by mole and from 0 to 98 % by mole, respectively.

**3.** The method of forming a fine resist pattern of Claim 1, wherein said fluorine-containing polymer is represented by the formula (3):

$$-(M1)-(M2\text{-}2)-(A1)- \quad (3)$$

wherein the structural unit M2-2 is a structural unit having an aliphatic polycyclic condensed structure in the polymer trunk chain, in which at least one fluorine atom and/or a fluorine-containing alkyl group which has 1 to 10 carbon atoms and may have ether bond is bonded to any of carbon atoms forming the aliphatic ring structure,
the structural unit M1 and A1 are as defined in the formula (1),
provided that at least any one of the structural units M1, M2-2 and A1 has an acid-reactive functional group Y, and contents of the structural units M1, M2-2 and A1 are from 1 to 99 % by mole, from 1 to 99 % by mole and from 0 to 98 % by mole, respectively.

**4.** The method of forming a fine resist pattern of any of Claims 1 to 3, wherein the structural unit M1 is a structural unit which is derived from at least one monomer selected from the group consisting of fluorine-containing ethylenic monomers having 2 or 3 carbon atoms and having at least one fluorine atom bonded to any of carbon atoms forming a trunk chain.

**5.** The method of forming a fine resist pattern of Claim 4, wherein the structural unit M1 is a structural unit derived from at least one monomer selected from the group consisting of tetrafluoroethylene and chlorotrifluoroethylene.

**6.** The method of forming a fine resist pattern of any of Claims 1 to 5, wherein each atom of the fluorine-containing

polymer satisfies Equation (X2):

$$N_T/(N_C - N_O + 4N_F^2) \leq 1.50 \qquad (X2).$$

**7.** The method of forming a fine resist pattern of any of Claims 1 to 6, wherein $F_2$ laser beam is used as said energy ray.

**8.** The method of forming a fine resist pattern of any of Claims 1 to 6, wherein ArF laser beam is used as said energy ray.

**9.** The method of forming a fine resist pattern of any of Claims 1 to 6, wherein KrF laser beam is used as said energy ray.

**10.** The method of forming a fine resist pattern of any of Claims 1 to 6, wherein high energy electron beam is used as said energy ray.

**11.** The method of forming a fine resist pattern of any of Claims 1 to 6, wherein high energy ion beam is used as said energy ray.

**12.** The method of forming a fine resist pattern of any of Claims 1 to 6, wherein X-ray is used as said energy ray.

**13.** A method of forming a fine circuit pattern comprising, after forming the fine resist pattern by the method of any of Claims 1 to 12 on a substrate or on a given layer on the substrate, a step for forming an intended circuit pattern by etching said substrate or said given layer through the fine resist pattern.

FIG. 1(a)

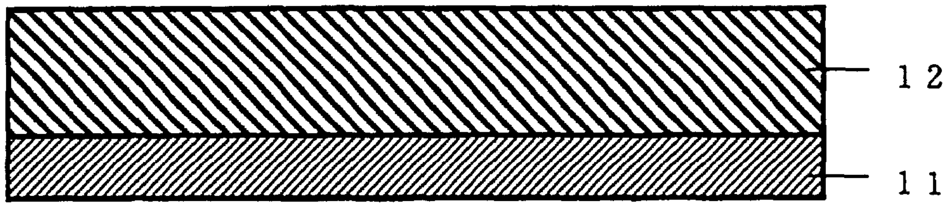


FIG. 1(b)

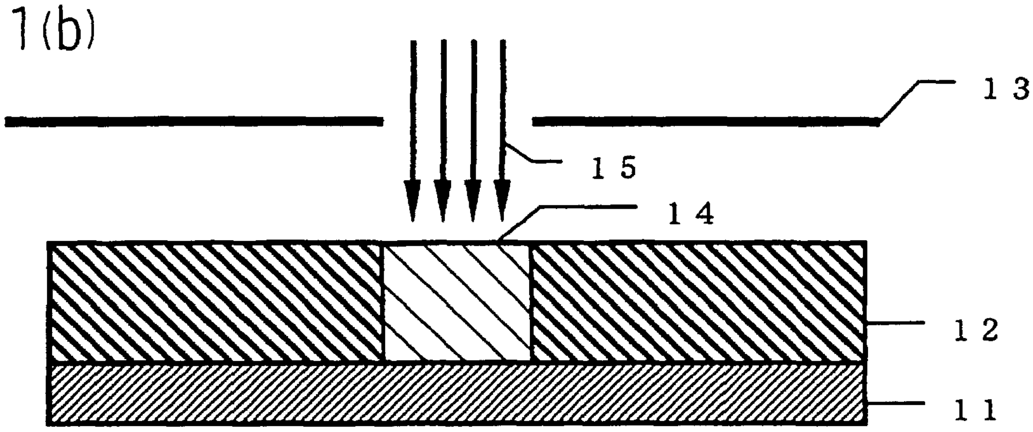


FIG. 1(c)

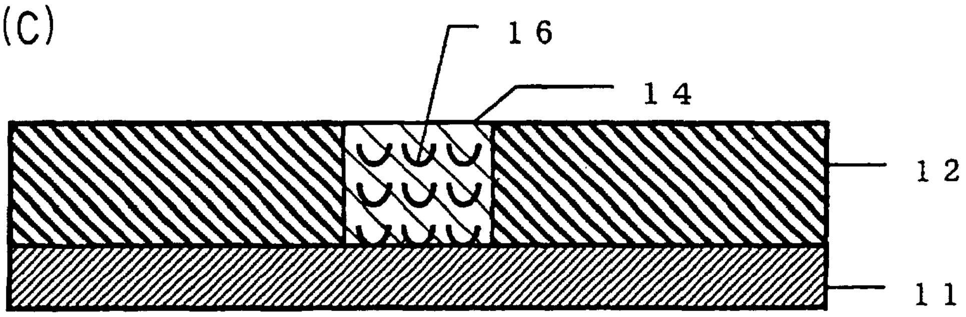


FIG. 1(d)

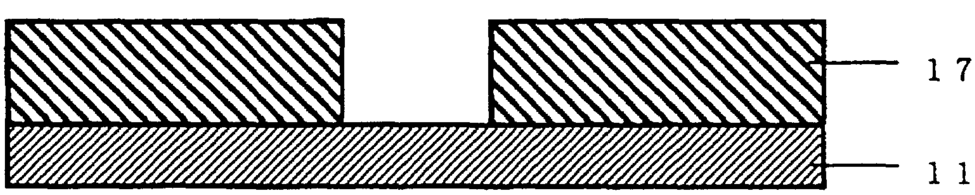

FIG. 2

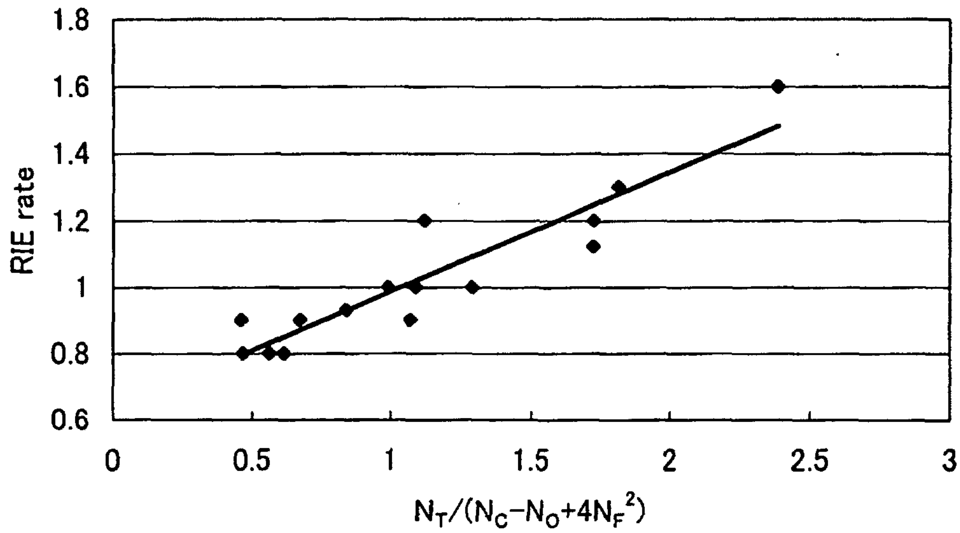

## INTERNATIONAL SEARCH REPORT

International application No.
PCT/JP02/10243

A. CLASSIFICATION OF SUBJECT MATTER
Int.Cl$^7$ G03F7/039, H01L21/027

According to International Patent Classification (IPC) or to both national classification and IPC

B. FIELDS SEARCHED

Minimum documentation searched (classification system followed by classification symbols)
Int.Cl$^7$ G03F7/00-7/42, H01L21/027

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2002 |
| Kokai Jitsuyo Shinan Koho | 1971-2002 | Jitsuyo Shinan Toroku Koho | 1996-2002 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P,X | JP 2002-169287 A (Fuji Photo Film Co., Ltd.), 14 June, 2002 (14.06.02), Claims & KR 2002042503 A | 1-13 |
| P,X | JP 2002-155117 A (Shin-Etsu Chemical Co., Ltd.), 28 May, 2002 (28.05.02), Claims (Family: none) | 1-13 |
| P,X | JP 2001-296662 A (Asahi Glass Co., Ltd.), 26 October, 2001 (26.10.01), Claims & JP 2001-350263 A | 1-13 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 10 January, 2003 (10.01.03) | 28 January, 2003 (28.01.03) |
| Name and mailing address of the ISA/ Japanese Patent Office | Authorized officer |
| Facsimile No. | Telephone No. |

Form PCT/ISA/210 (second sheet) (July 1998)

**INTERNATIONAL SEARCH REPORT**

International application No.
PCT/JP02/10243

C (Continuation). DOCUMENTS CONSIDERED TO BE RELEVANT

| Category* | Citation of document, with indication, where appropriate, of the relevant passages | Relevant to claim No. |
|---|---|---|
| X | JP 2001-81141 A (Hyundai Electronics Industries Co., Ltd.),<br>27 March, 2001 (27.03.01),<br>Claims<br>& US 6387589 B1 & KR 2001018076 A | 1-13 |
| Y | WO 00/67072 A (E.I. DU PONT DE NEMOURS AND CO.),<br>09 November, 2000 (09.11.00),<br>Claims<br>& JP 2002-543469 A & EP 1183571 A<br>& AU 200046781 A & CN 1357116 A<br>& KR 2002012206 A | 1-13 |
| Y | WO 00/17712 A (E.I. DU PONT DE NEMOURS AND CO.),<br>30 March, 2000 (30.03.00),<br>Claims<br>& JP 2002-525683 A & EP 1131677 A<br>& AU 9960560 A & CN 1319199 A | 1-13 |

Form PCT/ISA/210 (continuation of second sheet) (July 1998)